# EUROPEAN PATENT APPLICATION

(11) **EP 4 636 122 A1**
(43) Date of publication of application: **22.10.2025**
(21) Application number: 23903420.0
(22) Date of filing: 07.12.2023
(51) Int. Cl.: C23C 14/04, C23C 14/12, C23C 14/24

(54) **MASK AND METHOD FOR PRODUCING MASK**

(30) Priority: 16.12.2022 JP 2022201501
(71) Applicant: Dai Nippon Printing Co., Ltd., Tokyo 162-8001 (JP)
(72) Inventor: KITAYAMA, Daisuke, Tokyo 162-8001 (JP)
(74) Representative: Müller-Boré & Partner Patentanwälte PartG mbB
(86) International application number: PCT/JP2023/043872
(87) International publication number: WO 2024/128133

(57) **Abstract**

A mask includes a metal layer. The metal layer has a third surface, a fourth surface that is located opposite the third surface, and multiple second openings that extend from the third surface to the fourth surface. The metal layer has an effective region where the multiple second openings are formed and a peripheral region surrounding the effective region. The peripheral region includes a dummy region that is adjacent to the effective region so as to surround the effective region in a circumferential shape. Multiple recessed portions recessed from the fourth surface toward the third surface are formed in the dummy region.

## Description

### Technical Field

An embodiment of the present disclosure relates to a mask and a method of manufacturing a mask.

### Background Art

A vapor deposition method is known as a method of forming a precise pattern. In the vapor deposition method, a mask that has openings is first combined with a substrate. Subsequently, vapor deposition material is attached to the substrate via the openings of the mask. This enables a vapor deposition layer that contains the vapor deposition material to be formed on the substrate in a pattern that corresponds to the pattern of the openings of the mask. For example, the vapor deposition method is used as a method of forming the pixels of organic EL display devices.

For example, JP 2021-172879 A discloses a vapor deposition mask that includes a metal layer having the above-described openings. In JP 2021-172879 A, the metal layer is formed by using a plating method. With this method, first, multiple resin projections arranged in a pattern corresponding to the pattern of the openings are formed on a seed layer. Subsequently, metal is precipitated by using a plating method onto the seed layer where the resin projections have been formed. As a result, a metal layer having openings at the portions where the resin projections are disposed is formed.

The vapor deposition mask needs uniformity in the dimensions of the openings. In JP 2021-172879 A, the shape of each resin projection is made in a pyramidal or circular truncated cone shape, thus forming each of the openings of the metal layer in a tapered shape. In this case, if the thickness of the metal layer is not uniform, there occur variations in the dimensions of the openings. Therefore, forming the metal layer by using a plating method is problematic because the thickness of the metal layer becomes uneven in the region having the openings.

The embodiment of the present disclosure aims to manufacture a mask that can effectively solve such a problem.

### Summary of Invention

An embodiment of the present disclosure relates to a mask. The mask may include
a first layer having a first surface, a second surface that is located opposite the first surface, and at least one first opening that extends from the first surface to the second surface; and
a metal layer having a third surface that faces the second surface, a fourth surface that is located opposite the third surface, and multiple second openings that extend from the third surface to the fourth surface and that overlap the at least one first opening in plan view,
the first layer may contain silicon or a silicon compound,
the metal layer may have an effective region where the multiple second openings are formed and a peripheral region surrounding the effective region,
the peripheral region may include a dummy region that is adjacent to the effective region so as to surround the effective region in a circumferential shape, and multiple recessed portions recessed from the fourth surface toward the third surface may be formed in the dummy region.

An embodiment of the present disclosure relates to a method of manufacturing a mask. The method may include
a step of preparing a multilayer body including a first layer having a first surface and a second surface that is located opposite the first surface, and a seed layer having a fifth surface that faces the second surface and a sixth surface that is located opposite the fifth surface;
a step of providing a first resist layer containing a positive resist on the sixth surface of the seed layer;
a step of forming multiple resist projections projecting from the sixth surface in a third region and a fourth region surrounding the third region on the sixth surface by exposing and developing the first resist layer;
a step of performing a first plating process to form a first metal layer having multiple openings corresponding to the multiple resist projections by precipitating metal on the sixth surface, where the multiple resist projections are formed in the third region and the fourth region;
a step of removing resist projections of the multiple resist projections that are located in the fourth region;
a step of performing a second plating process to form a second metal layer that closes openings that are located in the fourth region by precipitating the second metal layer on the first metal layer and the sixth surface, after the resist projection in the fourth region is removed;
a step of removing resist projections of the multiple resist projections that are located in the third region, after the second plating process;
a step of partly forming a second resist layer on the first surface of the first layer; and
a step of forming a first opening in the first layer by etching the first layer from the first surface side, and
each of the resist projections that are located in the third region may have a tapered surface that narrows inward as a distance from the sixth surface increases.

According to the embodiments of the present disclosure, it is possible to make the dimensions of the second openings of the metal layer more uniform.

### Brief Description of Drawings

[Fig. 1] Fig. 1 is a sectional view of an example of an organic device.
[Fig. 2] Fig. 2 is a diagram of an example of a vapor deposition apparatus that includes a mask.
[Fig. 3A] Fig. 3A is a plan view of an example of the mask when viewed from a position in front of an entrance surface.
[Fig. 3B] Fig. 3B is a plan view of a modification to the mask when viewed from a position in front of the entrance surface.
[Fig. 3C] Fig. 3C is a plan view of a modification to the mask when viewed from a position in front of the entrance surface.
[Fig. 4] Fig. 4 is a plan view of an example of the mask when viewed from a position in front of an exit surface.
[Fig. 5A] Fig. 5A is an enlarged view of a portion surrounded by the alternate long and two-short dashed line in Fig. 3A.
[Fig. 5B] Fig. 5B is an enlarged view of the portion surrounded by the alternate long and two-short dashed line in Fig. 4.
[Fig. 6A] Fig. 6A is a sectional view of the mask taken along the line VI-VI in Fig. 3A.
[Fig. 6B] Fig. 6B is an enlarged view of a portion surrounded by the alternate long and two-short dashed line in Fig. 6A.
[Fig. 7] Fig. 7 is a sectional view of a step in a method of manufacturing a mask.
[Fig. 8] Fig. 8 is a sectional view of a step in the method of manufacturing a mask.
[Fig. 9A] Fig. 9A is a sectional view of a step in the method of manufacturing a mask.
[Fig. 9B] Fig. 9B is an enlarged view of a portion surrounded by the alternate long and two-short dashed line in Fig. 9A.
[Fig. 9C] Fig. 9C is a plan view of resist projections along with an intermediate layer shown in Fig. 9A.
[Fig. 9D] Fig. 9D is an enlarged view of a portion surrounded by the alternate long and two-short dashed line in Fig. 9C.
[Fig. 10] Fig. 10 is a sectional view of a step in the method of manufacturing a mask.
[Fig. 11] Fig. 11 is a sectional view of a step in the method of manufacturing a mask.
[Fig. 12A] Fig. 12A is a sectional view of a step in the method of manufacturing a mask.
[Fig. 12B] Fig. 12B is an enlarged view of a portion surrounded by the alternate long and two-short dashed line in Fig. 12A.
[Fig. 13] Fig. 13 is a sectional view of a step in the method of manufacturing a mask.
[Fig. 14] Fig. 14 is a sectional view of a step in the method of manufacturing a mask.
[Fig. 15] Fig. 15 is a sectional view of a step in the method of manufacturing a mask.
[Fig. 16] Fig. 16 is a sectional view of a step in the method of manufacturing a mask.
[Fig. 17] Fig. 17 is a sectional view of a step in the method of manufacturing a mask.
[Fig. 18] Fig. 18 is a sectional view of a step in the method of manufacturing a mask.
[Fig. 19] Fig. 19 is a sectional view of a step in the method of manufacturing a mask.
[Fig. 20] Fig. 20 is a view corresponding to Fig. 4 and is a plan view of a modification to the mask.
[Fig. 21] Fig. 21 is a partially sectional view of the mask taken along the line XXI-XXI in Fig. 20.
[Fig. 22] Fig. 22 is a view corresponding to Fig. 6A and is a sectional view of a modification to the mask.
[Fig. 23] Fig. 23 is a view of an example of a device that includes an organic device.

### Description of Embodiments

Hereinafter, the structure of a mask and a method of manufacturing the mask according to an embodiment will be described in detail with reference to the drawings. Embodiments described below are examples of the embodiments of the present disclosure, and the present disclosure should not be interpreted limitedly to these embodiments. In the specification, the terms "plate", "base", "sheet", "film", and the like are not distinguished from each other by the name difference. For example, "plate" is a concept including a member that can be called a sheet or a film. A "surface" refers to a surface that coincides with a planar direction of a member that is a target in a case where the target member is viewed from an overall and macro perspective. A normal direction refers to a normal direction to a surface of a member. Terms "parallel", "orthogonal", and the like, values of length and angle, and the like that determine shapes, geometrical conditions and the degrees of them, used in the specification, are not limited to strict meanings and are interpreted so as to include the range of degrees to which similar functions can be expected.

In the specification and the attached drawings, unless otherwise described, when a component of a member, a region, or the like is "on" or "under", "upper side" or "lower side", or "upward" or "downward" of another component of another member, another region, or the like, it includes a case where the component is directly in contact with the other component. Furthermore, it also includes a case where another component is included between the component and the other component, that is, the component and the other component are indirectly in contact with each other. Unless otherwise described, words "up", "upper side", and "upward", or "down", "lower side", and "downward" may be inverted upside down.

In the specification and the attached drawings, unless otherwise described, the same or similar reference signs denote the same portions or portions having similar functions, and the repeated description can be omitted. The scale ratio of the drawings can be different from the actual ratio for the sake of convenience of illustration, and one or some components can be omitted from the drawings.

In the specification and the attached drawings, unless otherwise described, an embodiment of the present disclosure may be combined with another embodiment or a modification without any contradiction. Alternatively, other embodiments or another embodiment and a modification may also be combined with each other without any contradiction. Alternatively, modifications may also be combined with each other without any contradiction.

In the specification and the attached drawings, unless otherwise described, when a plurality of steps will be described for a method, such as a manufacturing method, another undisclosed step may be performed between the disclosed steps. The order of disclosed steps may be selected without any contradiction.

In an example described according to an embodiment of the present specification, a mask is used to form an organic layer or an electrode on a substrate when an organic EL display device is manufactured. However, the use of the mask is not particularly limited, and the present embodiment can be applied to masks that are used for other purposes. For example, the mask according to the present embodiment may be used to form a layer such as an organic layer and an electrode of a device that displays or projects an image or a picture for expressing virtual reality, so-called VR, or augmented reality, so-called AR. Alternatively, the mask according to the present embodiment may be used to form a layer of a display device other than an organic EL display device, such as an electrode of a liquid-crystal display device. Alternatively, the mask according to the present embodiment may be used to form a layer of an organic device other than a display device, such as an organic layer and an electrode of a pressure sensor.

A mask according to a first aspect of the present disclosure includes
a first layer having a first surface, a second surface that is located opposite the first surface, and at least one first opening that extends from the first surface to the second surface; and
a metal layer having a third surface that faces the second surface, a fourth surface that is located opposite the third surface, and multiple second openings that extend from the third surface to the fourth surface and that overlap the at least one first opening in plan view,
the first layer contains silicon or a silicon compound,
the metal layer has an effective region where the multiple second openings are formed and a peripheral region surrounding the effective region,
the peripheral region includes a dummy region that is adjacent to the effective region so as to surround the effective region in a circumferential shape, and multiple recessed portions recessed from the fourth surface toward the third surface are formed in the dummy region.

As for a second aspect of the mask according to the first aspect described above, the mask may include a seed layer that is located between the second surface and the third surface.

As for a third aspect of the mask according to the second aspect described above, the seed layer may have electrical conductivity.

As for a fourth aspect of the mask according to any one of the first aspect described above to the third aspect described above, the mask may include a stopper layer between the second surface and the third surface.

As for a fifth aspect of the mask according to any one of the first aspect described above to the fourth aspect described above,
each of the second openings may be defined by a wall surface connecting the third surface to the fourth surface, and
the wall surface may have a tapered surface that widens outward toward the fourth surface.

As for a sixth aspect of the mask according to any one of the first aspect described above to the fifth aspect described above, a width of the dummy region may be 0.6 mm or more.

As for a seventh aspect of the mask according to any one of the first aspect described above to the sixth aspect described above, the number of the recessed portions per unit area in the dummy region may be 0.7 times or more and 1.3 times or less the number of the second openings per unit area in the effective region.

As for an eighth aspect of the mask according to any one of the first aspect described above to the seventh aspect described above, a pitch of the recessed portions may be 0.7 times or more and 1.3 times or less a pitch of the second openings.

As for a ninth aspect of the mask according to any one of the first aspect described above to the eighth aspect described above, an interval between a second opening of the second openings that is located at an outermost peripheral side of the effective region and a recessed portion of the recessed portions that is closest to the second opening that is located at the outermost peripheral side may be 0.7 times or more and 1.3 times or less a pitch of the second openings.

As for a tenth aspect of the mask according to any one of the first aspect described above to the ninth aspect described above,
a thickness of the metal layer may be 2 µm or more and 7 µm or less,
each of the recessed portions may extend over a part of a thickness of the metal layer from the fourth surface, and
a thickness of a bottom portion of each of the recessed portions may be 0.5 µm or more and 1.5 µm or less.

A method of manufacturing a mask according to an eleventh aspect of the present disclosure includes
a step of preparing a multilayer body including a first layer having a first surface and a second surface that is located opposite the first surface, and a seed layer having a fifth surface that faces the second surface and a sixth surface that is located opposite the fifth surface;
a step of providing a first resist layer containing a positive resist on the sixth surface of the seed layer;
a step of forming multiple resist projections projecting from the sixth surface in a third region and a fourth region surrounding the third region on the sixth surface by exposing and developing the first resist layer;
a step of performing a first plating process to form a first metal layer having multiple openings corresponding to the multiple resist projections by precipitating metal on the sixth surface, where the multiple resist projections are formed in the third region and the fourth region;
a step of removing resist projections of the multiple resist projections that are located in the fourth region;
a step of removing resist projections of the multiple resist projections that are located in the third region;
a step of partly forming a second resist layer on the first surface of the first layer; and
a step of forming a first opening in the first layer by etching the first layer from the first surface side, wherein
each of the resist projections that are located in the third region has a tapered surface that narrows inward as a distance from the sixth surface increases.

As for a twelfth aspect of the method of manufacturing a mask according to the eleventh aspect described above, the method may include
a step of performing a second plating process to form a second metal layer that closes at least part of openings in the first metal layer that are located in the fourth region by precipitating the second metal layer on the first metal layer and the sixth surface, after the step of removing the resist projections that are located in the fourth region and before the step of removing the resist projections that are located in the third region.

As for a thirteenth aspect of the method of manufacturing a mask according to the twelfth aspect described above,
the seed layer may have electrical conductivity, and
the first plating process and the second plating process may be electroplating processes.

As for a fourteenth aspect of the method of manufacturing a mask according to any one of the eleventh aspect described above to the thirteenth aspect described above, the method may include a step of removing part of the seed layer that overlaps the first opening in plan view, after the step of forming the first opening in the first layer.

As for a fifteenth aspect of the method of manufacturing a mask according to any one of the eleventh aspect described above to the fourteenth aspect described above,
the multilayer body may include a stopper layer between the first layer and the seed layer, and
the method of manufacturing a mask may further include a step of removing the stopper layer after the step of forming the first opening in the first layer.

As for a sixteenth aspect of the method of manufacturing a mask according to the twelfth aspect described above or the thirteenth aspect described above, the method may include:
a step of forming a protection layer covering the second metal layer after the second plating process and before the first opening is formed; and
a step of removing the protection layer after the first opening is formed in the first layer.

As for a seventeenth aspect of the method of manufacturing a mask according to any one of the eleventh aspect described above to the sixteenth aspect described above, a width of the fourth region may be 0.6 mm or more.

As for an eighteenth aspect of the method of manufacturing a mask according to any one of the twelfth aspect described above, the thirteenth aspect described above, and the sixteenth aspect described above,
a thickness of the first metal layer may be 0.5 µm or more and 6.5 µm or less, and
a thickness of the second metal layer may be 0.5 µm or more and 1.5 µm or less.

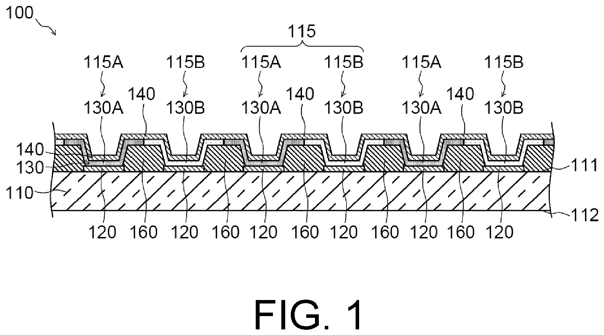

An embodiment will be described with reference to Fig. 1 to Fig. 23. An organic device 100 that includes an organic layer that is formed by using a mask will now be described. Fig. 1 is a sectional view of an example of the organic device 100.

The organic device 100 includes a substrate 110 and multiple elements 115 that are arranged in an in-plane direction of the substrate 110. The substrate 110 has a first surface 111 and a second surface 112 that is located opposite the first surface 111. The elements 115 are located on the first surface 111. Examples of the elements 115 are pixels. The substrate 110 may include two or more kinds of the elements 115. For example, the substrate 110 may include first elements 115A and second elements 115B. The substrate 110 may include third elements although not illustrated. For example, the first elements 115A, the second elements 115B, and the third elements are red pixels, blue pixels, and green pixels.

Each of the elements 115 may include a first electrode 120, an organic layer 130 that is located on the first electrode 120, and a second electrode 140 that is located on the organic layer 130.

The organic device 100 may include insulating layers 160 each of which is located between two of the first electrodes 120 adjacent to each other in plan view. For example, the insulating layers 160 contain polyimide. The insulating layers 160 may overlap end portions of the first electrodes 120. The words "in plan view" mean that an object is viewed in the normal direction of a surface of a plate member such as the substrate 110.

The substrate 110 may be an insulating member. Examples of the material of the substrate 110 can include rigid materials that are not flexible such as silicon, quartz glass, Pyrex (registered trademark) glass, and a synthetic quartz plate and flexible materials that are flexible such as a resin film, an optical resin sheet, and thin glass. The substrate 110 may have the same planar shape as that of a silicon wafer that is used for manufacturing semiconductors. In this case, the substrate 110 can be processed by using an apparatus that performs a semiconductor manufacturing process. For example, the first electrodes 120 and the insulating layers 160 can be formed on the substrate 110 by using the apparatus that performs the semiconductor manufacturing process.

Each of the elements 115 is configured to fulfill a function when a voltage is applied between the first electrode 120 and the second electrode 140 or a current flows between the first electrode 120 and the second electrode 140. For example, in the case where the elements 115 are pixels of an organic EL display device, the elements 115 are capable of emitting light for forming a picture.

The first electrodes 120 contain a conductive material. For example, the first electrodes 120 contain a metal, a conductive metal oxide, or another conductive inorganic material. The first electrodes 120 may contain a transparent, conductive metal oxide, such as an indium tin oxide.

The organic layers 130 contain an organic material. When the organic layers 130 are energized, the organic layers 130 can perform a function. The phrase "to be energized" means that a voltage is applied to the organic layers 130, or a current flows through the organic layers 130. Examples of the organic layers 130 can include light-emitting layers that emit light when being energized and layers the refractive index or the optical transmittance of which changes when being energized. The organic layers 130 may contain an organic semiconductor material.

As illustrated in Fig. 1, the organic layers 130 may include first organic layers 130A and second organic layers 130B. The first organic layers 130A are included in the first elements 115A. The second organic layers 130B are included in the second elements 115B. The organic layers 130 may include third organic layers that are included in the third elements although not illustrated. For example, the first organic layers 130A, the second organic layers 130B, and the third organic layers are red light-emitting layers, blue light-emitting layers, and green light-emitting layers.

When a voltage is applied between the first electrode 120 and the second electrode 140, the organic layer 130 that is located therebetween is driven. In the case where the organic layers 130 are light-emitting layers, light is emitted from the organic layers 130, and the light exits from the second electrodes 140 or the first electrodes 120 to the outside.

The organic layers 130 may further include a hole injection layer, a hole transport layer, an electron transport layer, an electron injection layer, and another layer.

The second electrodes 140 may contain a conductive material such as a metal. Examples of the material of the second electrodes 140 can include platinum, gold, silver, copper, iron, tin, chromium, aluminum, indium, lithium, sodium, potassium, calcium, magnesium, carbon, and alloys of them. As illustrated in Fig. 1, the second electrode 140 may extend across two of the organic layers 130 adjacent to each other in plan view.

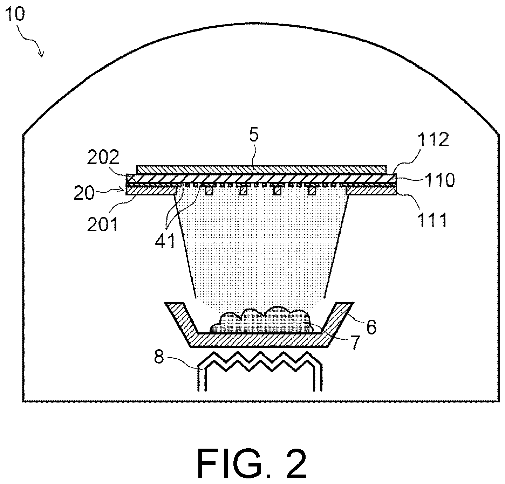

A method of forming the organic layers 130 on the substrate 110 by using the vapor deposition method will now be described. Fig. 2 illustrates a vapor deposition apparatus 10. The vapor deposition apparatus 10 performs a vapor deposition process in which a vapor deposition material is deposited on an object.

As illustrated in Fig. 2, the vapor deposition apparatus 10 may include a vapor deposition source 6, a heater 8, and a mask 20 therein. The vapor deposition apparatus 10 may further include an evacuating unit for creating a vacuum atmosphere in the vapor deposition apparatus 10. An example of the vapor deposition source 6 is a crucible. The vapor deposition source 6 contains a vapor deposition material 7, such as an organic material and a metal material. The heater 8 heats the vapor deposition source 6 and vaporizes the vapor deposition material 7 in the vacuum atmosphere.

The mask 20 has an entrance surface 201, an exit surface 202, and second openings 41. The entrance surface 201 faces the vapor deposition source 6. The exit surface 202 is located opposite the entrance surface 201. The exit surface 202 faces the first surface 111 of the substrate 110. Part of the vapor deposition material 7 that enters the mask 20 via the entrance surface 201 passes through the second openings 41 and exits via the exit surface 202. The vapor deposition material 7 that exits via the exit surface 202 adheres to the first surface 111 of the substrate 110. The exit surface 202 of the mask 20 may be in contact with the first surface 111 of the substrate 110.

As illustrated in Fig. 2, the vapor deposition apparatus 10 may include a magnet 5 that is disposed on the second surface 112 of the substrate 110. In the case where the mask 20 contains a metal material, the magnet 5 is capable of attracting the mask 20 toward the substrate 110 due to magnetic force. This enables a gap between the mask 20 and the substrate 110 to be reduced or enables the gap to be eliminated. This enables shadow to be inhibited from occurring at a vapor deposition step. In the present application, the shadow means a phenomenon in which the thicknesses of the organic layers 130 that are formed near wall surfaces of the second openings 41 are less than the thicknesses of the organic layers 130 at the centers of the second openings 41. The shadow occurs, for example, due to the vapor deposition material 7 that adheres to a wall surface of the mask 20 or the vapor deposition material 7 that enters the gap between the mask 20 and the substrate 110.

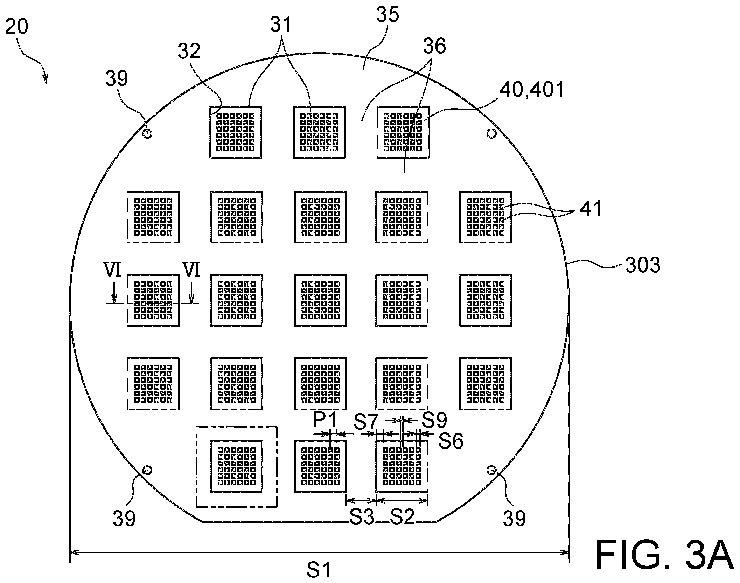

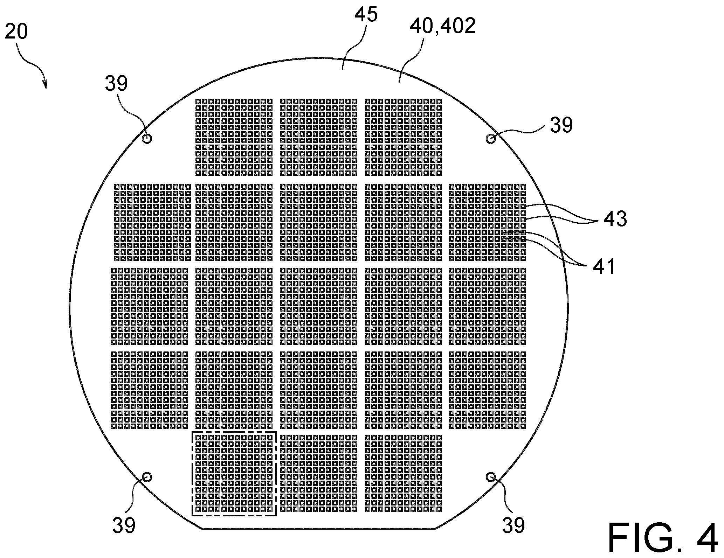

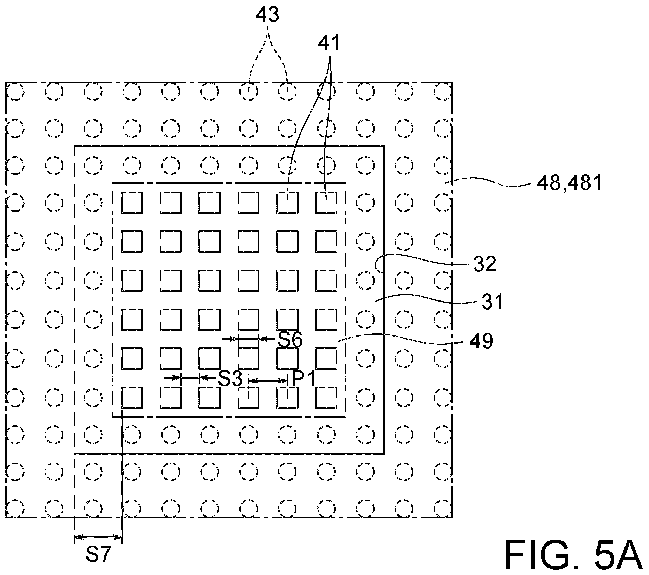

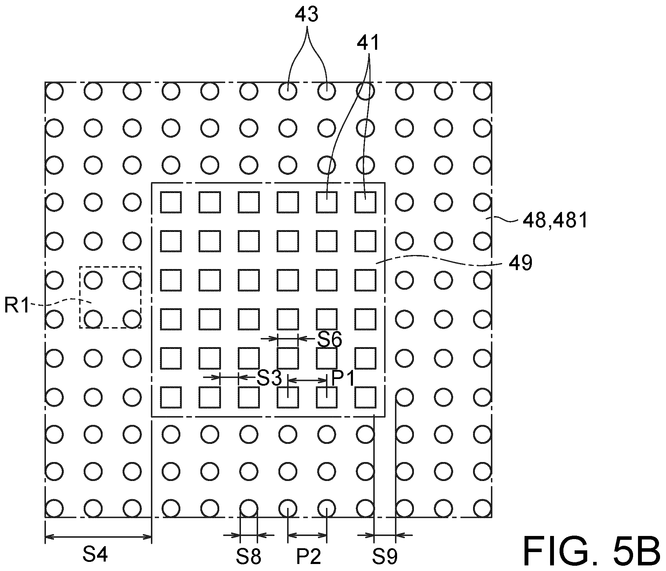

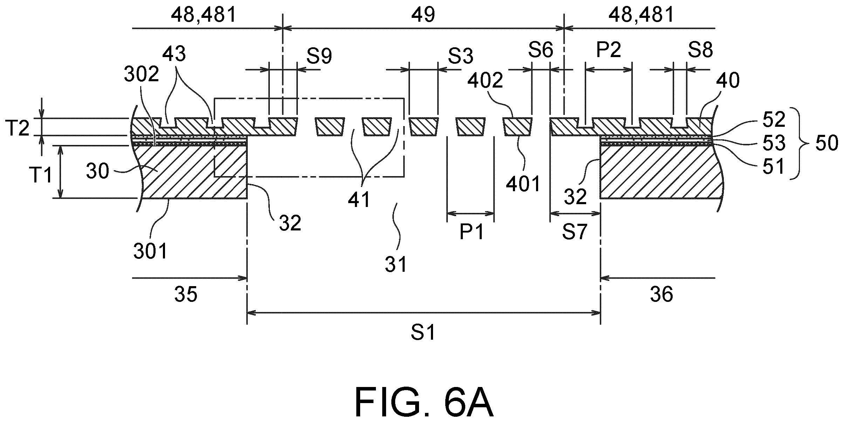

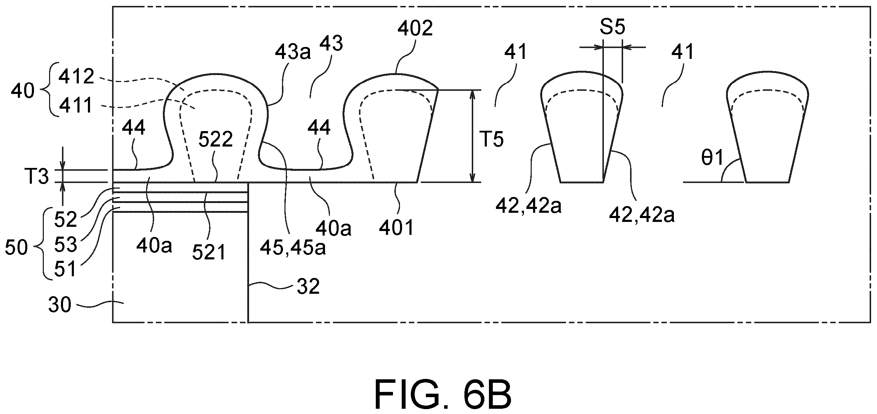

The mask 20 will now be described in detail. Fig. 3A is a plan view of an example of the mask 20 when viewed from a position in front of the entrance surface 201. Fig. 4 is a plan view of an example of the mask 20 when viewed from a position in front of the exit surface 202. Fig. 5A is an enlarged view of a portion surrounded by the alternate long and two-short dashed line in Fig. 3A. Fig. 5B is an enlarged view of the portion surrounded by the alternate long and two-short dashed line in Fig. 4. Fig. 6A is a sectional view of the mask 20 taken along the VI-VI line in Fig. 3A. Fig. 6B is an enlarged view of a portion surrounded by the alternate long and two-short dashed line in Fig. 6A.

As illustrated in Fig. 6A, the mask 20 includes a first layer 30, an intermediate layer 50, and a metal layer 40 that are arranged in order from the entrance surface 201 to the exit surface 202. The first layer 30 contains silicon or a silicon compound. An example of the silicon compound is silicon carbide (SiC). For example, the metal layer 40 contains a metal material. The layers will be described below.

The first layer 30 has a first surface 301, a second surface 302, a first opening 31, and a first wall surface 32. The first surface 301 may form the entrance surface 201. The second surface 302 is located opposite the first surface 301.

The first opening 31 extends from the first surface 301 to the second surface 302. As illustrated in Fig. 3A, the first layer 30 may have multiple first openings 31. The multiple first openings 31 may be arranged in a first direction D1 and a second direction D2. The second direction D2 may be orthogonal to the first direction D1.

The first opening 31 may correspond to a single screen of an organic EL display device. The mask 20 illustrated in Fig. 3A enables the pattern of organic layers that correspond to multiple screens to be simultaneously formed on the substrate 110. As illustrated in Fig. 3A, the first opening 31 may have a rectangular contour in plan view.

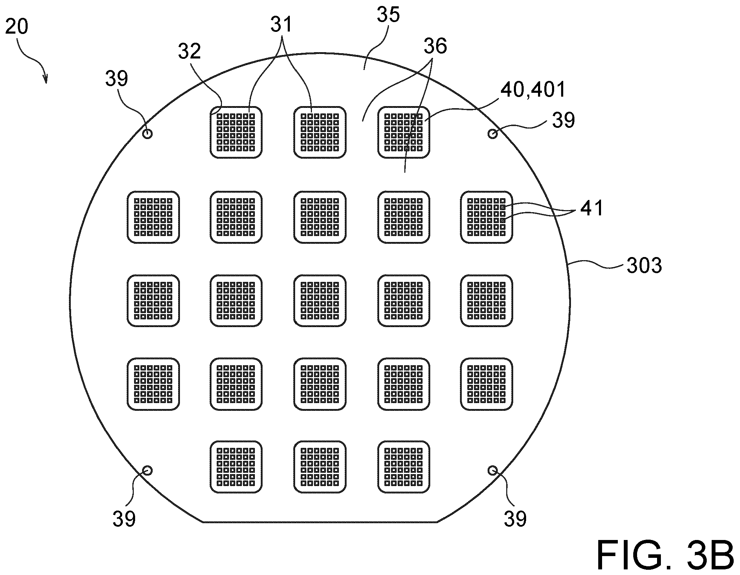

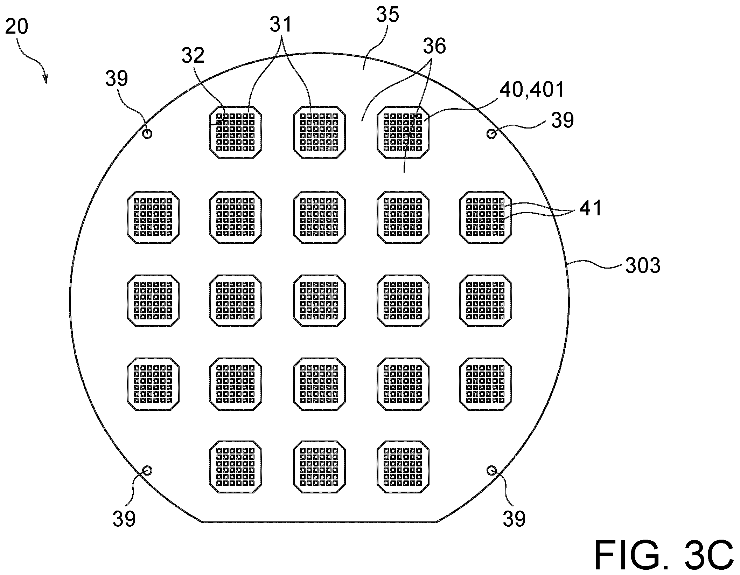

Fig. 3B and Fig. 3C are plan views of other examples of the mask 20. As illustrated in Fig. 3B, corner portions of the contour of each first opening 31 may include curved portions. As illustrated in Fig. 3C, the contour of each first opening 31 may have an octagonal shape. In the examples illustrated in Fig. 3B and Fig. 3C, stress can be inhibited from concentrating on the corner portions in the case where the stress is applied to the contour of each first opening 31. For this reason, the first layer 30 can be inhibited from being damaged.

The first wall surface 32 is a surface of the first layer 30, facing the first opening 31. In the example illustrated in Fig. 3A, the first wall surfaces 32 extend in the normal direction of the first surface 301.

As illustrated in Fig. 3A, a region of the first layer 30 in which the first openings 31 are not formed may be divided into an outer region 35 and an inner region 36. The inner region 36 is located between two of the first openings 31 adjacent to each other in plan view. The outer region 35 is located between an outer edge 303 of the first layer 30 and the first openings 31 in plan view. As illustrated in Fig. 3A, the inner region 36 may extend in the first direction D1 and the second direction D2 through between the two first openings 31.

As illustrated in Fig. 3A and Fig. 4, the first layer 30 may have alignment marks 39. For example, the alignment marks 39 are formed on the second surface 302. The alignment marks 39 may be formed on the first surface 301. For example, the alignment marks 39 are used to adjust the relative position of the substrate 110 with respect to the mask 20. In the case where the substrate 110 has properties that enable visible light to pass therethrough, the alignment marks 39 can be visually recognized through the substrate 110. In the case where the substrate 110 has properties that enable infrared light to pass therethrough, the alignment marks 39 can be visually recognized through the substrate 110 using an infrared camera.

As illustrated in Fig. 3A and Fig. 4, the alignment marks 39 may have a circular contour in plan view. The alignment marks 39 may have a contour that has another shape other than a circular shape, such as a rectangular shape and a cross shape, although not illustrated. The alignment marks 39 may be located in the outer region 35 or may be located in the inner region 36.

The first layer 30 contains silicon or a silicon compound as described above. For example, the first layer 30 is manufactured by processing a silicon wafer. As illustrated in Fig. 3A, the outer edge 303 of the first layer 30 may include a straight portion. The straight portion is also referred to as an orientation flat. The outer edge 303 may include a cut portion, although not illustrated. The cut portion is also referred to as a notch. The orientation flat and the notch represent the crystal orientation of the silicon wafer.

For example, the maximum dimension S1 of the first layer 30 in plan view may be 100 mm or more, may be 150 mm or more, or may be 250 mm or more. For example, the dimension S1 may be 300 mm or less, may be 400 mm or less, or may be 500 mm or less. The range of the dimension S1 may be determined by using a first group consisting of 100 mm, 150 mm, and 250 mm and/or a second group consisting of 300 mm, 400 mm, and 500 mm. The range of the dimension S1 may be determined by using a combination of a value freely selected from the values in the first group described above and a value freely selected from the values in the second group described above. The range of the dimension S1 may be determined by using a combination of two values freely selected from the values in the first group described above. The range of the dimension S1 may be determined by using a combination of two values freely selected from the values in the second group described above. For example, the dimension S1 may be 100 mm or more and 500 mm or less, may be 100 mm or more and 400 mm or less, may be 100 mm or more and 300 mm or less, may be 100 mm or more and 250 mm or less, may be 100 mm or more and 150 mm or less, may be 150 mm or more and 500 mm or less, may be 150 mm or more and 400 mm or less, may be 150 mm or more and 300 mm or less, may be 150 mm or more and 250 mm or less, may be 250 mm or more and 500 mm or less, may be 250 mm or more and 400 mm or less, may be 250 mm or more and 300 mm or less, may be 300 mm or more and 500 mm or less, may be 300 mm or more and 400 mm or less, or may be 400 mm or more and 500 mm or less.

For example, the dimension S2 of each of the first openings 31 in a direction in which the first openings 31 are arranged may be 5 mm or more, may be 10 mm or more, or may be 20 mm or more. For example, the dimension S2 may be 30 mm or less, may be 50 mm or less, or may be 100 mm or less. The range of the dimension S2 may be determined by using a first group consisting of 5 mm, 10 mm, and 20 mm and/or a second group consisting of 30 mm, 50 mm, and 100 mm. The range of the dimension S2 may be determined by using a combination of a value freely selected from the values in the first group described above and a value freely selected from the values in the second group described above. The range of the dimension S2 may be determined by using a combination of two values freely selected from the values in the first group described above. The range of the dimension S2 may be determined by using a combination of two values freely selected from the values in the second group described above. For example, the dimension S2 may be 5 mm or more and 100 mm or less, may be 5 mm or more and 50 mm or less, may be 5 mm or more and 30 mm or less, may be 5 mm or more and 20 mm or less, may be 5 mm or more and 10 mm or less, may be 10 mm or more and 100 mm or less, may be 10 mm or more and 50 mm or less, may be 10 mm or more and 30 mm or less, may be 10 mm or more and 20 mm or less, may be 20 mm or more and 100 mm or less, may be 20 mm or more and 50 mm or less, may be 20 mm or more and 30 mm or less, may be 30 mm or more and 100 mm or less, may be 30 mm or more and 50 mm or less, or may be 50 mm or more and 100 mm or less.

For example, an interval S3 between two of the first openings 31 in the direction in which the first openings 31 are arranged may be 0.1 mm or more, may be 0.5 mm or more, or may be 1.0 mm or more. For example, the interval S3 may be 10 mm or less, may be 15 mm or less, or may be 20 mm or less. The range of the interval S3 may be determined by using a first group consisting of 0.1 mm, 0.5 mm, and 1.0 mm and/or a second group consisting of 10 mm, 15 mm, and 20 mm. The range of the interval S3 may be determined by using a combination of a value freely selected from the values in the first group described above and a value freely selected from the values in the second group described above. The range of the interval S3 may be determined by using a combination of two values freely selected from the values in the first group described above. The range of the interval S3 may be determined by using a combination of two values freely selected from the values in the second group described above. For example, the interval S3 may be 0.1 mm or more and 20 mm or less, may be 0.1 mm or more and 15 mm or less, may be 0.1 mm or more and 10 mm or less, may be 0.1 mm or more and 1.0 mm or less, may be 0.1 mm or more and 0.5 mm or less, may be 0.5 mm or more and 20 mm or less, may be 0.5 mm or more and 15 mm or less, may be 0.5 mm or more and 10 mm or less, may be 0.5 mm or more and 1.0 mm or less, may be 1.0 mm or more and 20 mm or less, may be 1.0 mm or more and 15 mm or less, may be 1.0 mm or more and 10 mm or less, may be 10 mm or more and 20 mm or less, may be 10 mm or more and 15 mm or less, or may be 15 mm or more and 20 mm or less.

The thickness of the first layer 30 is defined as the maximum thickness T1 of the outer region 35. For example, the thickness T1 may be 50 µm or more, may be 100 µm or more, or may be 200 µm or more. For example, the thickness T1 may be 600 µm or less, may be 800 µm or less, or may be 1000 µm or less. The range of the thickness T1 may be determined by using a first group consisting of 50 µm, 100 µm, and 200 µm and/or a second group consisting of 600 µm, 800 µm, and 1000 µm. The range of the thickness T1 may be determined by using a combination of a value freely selected from the values in the first group described above and a value freely selected from the values in the second group described above. The range of the thickness T1 may be determined by using a combination of two values freely selected from the values in the first group described above. The range of the thickness T1 may be determined by using a combination of two values freely selected from the values in the second group described above. For example, the thickness T1 may be 50 µm or more and 1000 µm or less, may be 50 µm or more and 800 µm or less, may be 50 µm or more and 600 µm or less, may be 50 µm or more and 200 µm or less, may be 50 µm or more and 100 µm or less, may be 100 µm or more and 1000 µm or less, may be 100 µm or more and 800 µm or less, may be 100 µm or more and 600 µm or less, may be 100 µm or more and 200 µm or less, may be 200 µm or more and 1000 µm or less, may be 200 µm or more and 800 µm or less, may be 200 µm or more and 600 µm or less, may be 600 µm or more and 1000 µm or less, may be 600 µm or more and 800 µm or less, or may be 800 µm or more and 1000 µm or less.

Next, the metal layer 40 will be described. The metal layer 40 includes a third surface 401, a fourth surface 402, the multiple second openings 41, and multiple recessed portions 43. The third surface 401 faces the second surface 302 of the first layer 30. The fourth surface 402 is located opposite the third surface 401.

The second openings 41 extend from the third surface 401 to the fourth surface 402. One of the second openings 41 corresponds to one of the organic layers 130. A group of the multiple second openings 41 that are regularly arranged corresponds to a single screen of an organic EL display device. As illustrated in Fig. 3A, a group of the multiple second openings 41 that are regularly arranged may overlap one of the first openings 31 in plan view.

The metal layer 40 may be divided into a peripheral region 48 (see Fig. 4 and Fig. 5B) and an effective region 49 (see Fig. 5B). The effective region 49 is a region in which a group of the multiple second openings 41 that are regularly arranged is distributed. The peripheral region 48 is a region that surrounds the effective region 49. At least a part of the peripheral region 48 overlaps the first layer 30 in plan view.

The peripheral region 48 includes a dummy region 481 (see Fig. 5B) where the multiple recessed portions 43 are formed. The dummy region 481 is adjacent to the effective region 49 so as to surround the effective region 49 in a circumferential shape. The recessed portions 43 are recessed from the fourth surface 402 toward the third surface 401. For example, the width S4 of the dummy region 481 is 0.6 mm or more, may be 0.7 mm or more, or may be 0.8 mm or more.

In the illustrated example, a part of the dummy region 481 overlaps the first opening 31 in plan view. For this reason, the part of the dummy region 481 does not overlap the first layer 30 in plan view. Of course, the configuration is not limited to this example, and the entire dummy region 481 may overlap the first layer 30 in plan view.

Fig. 6B illustrates an example of the effective region 49 and the dummy region 481. The metal layer 40 has second wall surfaces 42 that face the second openings 41. As illustrated in Fig. 6B, each of the second wall surfaces 42 may include a tapered surface 42a that gradually separates from the center of the second opening 41 as it approaches the third surface 401. The second wall surfaces 42 include the tapered surfaces 42a, and consequently, shadow can be inhibited from occurring near the second wall surfaces 42.

In Fig. 6B, the reference sign S5 represents the width of each tapered surface 42a in a direction in which the second openings 41 are arranged. For example, the width S5 may be 0.2 µm or more, may be 0.5 µm or more, or may be 1.0 µm or more. For example, the width S5 may be 10 µm or less, may be 20 µm or less, or may be 25 µm or less. The range of the width S5 may be determined by using a first group consisting of 0.2 µm, 0.5 µm, and 1.0 µm and/or a second group consisting of 10 µm, 20 µm, and 25 µm. The range of the width S5 may be determined by using a combination of a value freely selected from the values in the first group described above and a value freely selected from the values in the second group described above. The range of the width S5 may be determined by using a combination of two values freely selected from the values in the first group described above. The range of the width S5 may be determined by using a combination of two values freely selected from the values in the second group described above. For example, the width S5 may be 0.2 µm or more and 25 µm or less, may be 0.2 µm or more and 20 µm or less, may be 0.2 µm or more and 10 µm or less, may be 0.2 µm or more and 1.0 µm or less, may be 0.2 µm or more and 0.5 µm or less, may be 0.5 µm or more and 25 µm or less, may be 0.5 µm or more and 20 µm or less, may be 0.5 µm or more and 10 µm or less, may be 0.5 µm or more and 1.0 µm or less, may be 1.0 µm or more and 25 µm or less, may be 1.0 µm or more and 20 µm or less, may be 1.0 µm or more and 10 µm or less, may be 10 µm or more and 25 µm or less, may be 10 µm or more and 20 µm or less, or may be 20 µm or more and 25 µm or less.

In Fig. 6B, the reference sign θ1 represents an angle that is formed between each second wall surface 42 and the third surface 401. For example, the angle θ1 may be 50° or more, may be 55° or more, may be 60° or more, or may be 65° or more. For example, the angle θ1 may be 75° or less, may be 80° or less, may be 85° or less, or may be less than 90°. The range of the angle θ1 may be determined by using a first group consisting of 50°, 55°, 60°, and 65° and/or a second group consisting of 75°, 80°, 85°, and 90°. The range of the angle θ1 may be determined by using a combination of a value freely selected from the values in the first group described above and a value freely selected from the values in the second group described above. The range of the angle θ1 may be determined by using a combination of two values freely selected from the values in the first group described above. The range of the angle θ1 may be determined by using a combination of two values freely selected from the values in the second group described above. For example, the angle θ1 may be 50° or more and less than 90°, may be 50° or more and 85° or less, may be 50° or more and 80° or less, may be 50° or more and 75° or less, may be 50° or more and 65° or less, may be 50° or more and 60° or less, may be 50° or more and 55° or less, may be 55° or more and less than 90°, may be 55° or more and 85° or less, may be 55° or more and 80° or less, may be 55° or more and 75° or less, may be 55° or more and 65° or less, may be 55° or more and 60° or less, may be 60° or more and less than 90°, may be 60° or more and 85° or less, may be 60° or more and 80° or less, may be 60° or more and 75° or less, may be 60° or more and 65° or less, may be 65° or more and less than 90°, may be 65° or more and 85° or less, may be 65° or more and 80° or less, may be 65° or more and 75° or less, may be 75° or more and less than 90°, may be 75° or more and 85° or less, may be 75° or more and 80° or less, may be 80° or more and less than 90°, may be 80° or more and 85° or less, or may be 85° or more and less than 90°.

Each of the recessed portions 43 is defined by a bottom surface 44 and a third wall surface 45 that surrounds the bottom surface 44 in a circumferential shape. In other words, an end of each of the recessed portions 43 on the first layer 30 side is closed by the bottom surface 44. Thus, when a vapor deposition layer is formed on the substrate 110 by using the mask 20, adhesion of vapor deposition material from the vapor deposition source 6 to the substrate 110 through the recessed portions 43 is prevented.

The third wall surface 45 defines an opening part 43a of each of the recessed portions 43 at the fourth surface 402. The third wall surface 45 may include a tapered surface 45a that gradually separates from the center of the opening part 43a as it approaches the third surface 401. The width of the tapered surface 45a of the third wall surface 45 may be the same or similar to the tapered surface 42a of the second wall surface 42 of the second opening 41. The angle formed between the tapered surface 45a and the third surface 401 may be the same or similar to the angle θ1 formed between the second wall surface 42 of the second opening 41 and the fourth surface 402.

The metal layer 40 contains a metal material as described above. Examples of the metal material include nickel, nickel-cobalt alloys, iron-nickel alloys, and copper. As will be described later, the metal layer 40 includes a first metal layer 411 and a second metal layer 412. The first metal layer 411 and the second metal layer 412 may contain the same metal material or may contain different metal materials. The metal layer 40 may be formed by using, for example, an electroplating method.

The thickness of the metal layer 40 is defined as the distance T2 between the third surface 401 and the fourth surface 402. The thickness T2 of the metal layer 40 is less than the thickness T1 of the first layer 30. For example, the thickness T2 may be 2 µm or more, may be 3 µm or more, or may be 4 µm or more. For example, the thickness T2 may be 5 µm or less, may be 6 µm or less, or may be 7 µm or less. The range of the thickness T2 may be determined by using a first group consisting of 2 µm, 3 µm, and 4 µm and/or a second group consisting of 5 µm, 6 µm, and 7 µm. The range of the thickness T2 may be determined by using a combination of a value freely selected from the values in the first group described above and a value freely selected from the values in the second group described above. The range of the thickness T2 may be determined by using a combination of two values freely selected from the values in the first group described above. The range of the thickness T2 may be determined by using a combination of two values freely selected from the values in the second group described above. For example, the thickness T2 may be 2 µm or more and 7 µm or less, may be 2 µm or more and 6 µm or less, may be 2 µm or more and 5 µm or less, may be 2 µm or more and 4 µm or less, may be 2 µm or more and 3 µm or less, may be 3 µm or more and 7 µm or less, may be 3 µm or more and 6 µm or less, may be 3 µm or more and 5 µm or less, may be 3 µm or more and 4 µm or less, may be 4 µm or more and 7 µm or less, may be 4 µm or more and 6 µm or less, may be 4 µm or more and 5 µm or less, may be 5 µm or more and 7 µm or less, may be 5 µm or more and 6 µm or less, or may be 6 µm or more and 7 µm or less. When the thickness T2 is 7 µm or less, shadow can be inhibited from occurring. When the thickness T2 is 2 µm or more, the metal layer 40 can be inhibited, for example, from having a defect such as a pinhole and from deforming.

In the illustrated example, each of the recessed portions 43 extends over a part of the thickness T2 of the metal layer 40 from the fourth surface 402 of the metal layer 40. Each of the recessed portions 43 has a bottom portion 40a formed by a part of the metal layer 40. The bottom portion 40a of each of the recessed portions 43 is a region of the metal layer 40 between the bottom surface 44 of each of the recessed portions 43 and the third surface 401 of the metal layer 40. The thickness of the bottom portion 40a of each of the recessed portions 43 is defined as the distance T3 between the bottom surface 44 of each of the recessed portions 43 and the third surface 401 of the metal layer 40. The thickness T3 of the bottom portion 40a of each of the recessed portions 43 is, as will be described later, the thickness of the second metal layer 412. For example, the thickness T3 may be 0.5 µm or more, may be 0.70 µm or more, or may be 0.90 µm or more. For example, the thickness T3 may be 1.0 µm or less, may be 1.25 µm or less, or may be 1.5 µm or less. The range of the thickness T3 may be determined by using a first group consisting of 0.5 µm, 0.70 µm, and 0.90 µm and/or a second group consisting of 1.0 µm, 1.25 µm, and 1.5 µm. The range of the thickness T3 may be determined by a combination of a value freely selected from the values in the first group described above and a value freely selected from the values in the second group described above. The range of the thickness T3 may be determined by using a combination of two values freely selected from the values in the first group described above. The range of the thickness T3 may be determined by using a combination of two values freely selected from the values in the second group described above. For example, the thickness T3 may be 0.5 µm or more and 1.5 µm or less, may be 0.5 µm or more and 1.25 µm or less, may be 0.5 µm or more and 1.0 µm or less, may be 0.5 µm or more and 0.90 µm or less, may be 0.5 µm or more and 0.70 µm or less, may be 0.70 µm or more and 1.5 µm or less, may be 0.70 µm or more and 1.25 µm or less, may be 0.70 µm or more and 1.0 µm or less, may be 0.70 µm or more and 0.90 µm or less, may be 0.90 µm or more and 1.5 µm or less, may be 0.90 µm or more and 1.25 µm or less, may be 0.90 µm or more and 1.0 µm or less, may be 1.0 µm or more and 1.5 µm or less, may be 1.0 µm or more and 1.25 µm or less, or may be 1.25 µm or more and 1.5 µm or less.

For example, the dimension S6 of each second opening 41 in plan view may be 1 µm or more, may be 2 µm or more, or may be 3 µm or more. For example, the dimension S6 may be 5 µm or less, may be 10 µm or less, or may be 25 µm or less. The range of the dimension S6 may be determined by using a first group consisting of 1 µm, 2 µm, and 3 µm and/or a second group consisting of 5 µm, 10 µm, and 25 µm. The range of the dimension S6 may be determined by using a combination of a value freely selected from the values in the first group described above and a value freely selected from the values in the second group described above. The range of the dimension S6 may be determined by using a combination of two values freely selected from the values in the first group described above. The range of the dimension S6 may be determined by using a combination of two values freely selected from the values in the second group described above. For example, the dimension S6 may be 1 µm or more and 25 µm or less, may be 1 µm or more and 10 µm or less, may be 1 µm or more and 5 µm or less, may be 1 µm or more and 3 µm or less, may be 1 µm or more and 2 µm or less, may be 2 µm or more and 25 µm or less, may be 2 µm or more and 10 µm or less, may be 2 µm or more and 5 µm or less, may be 2 µm or more and 3 µm or less, may be 3 µm or more and 25 µm or less, may be 3 µm or more and 10 µm or less, may be 3 µm or more and 5 µm or less, may be 5 µm or more and 25 µm or less, may be 5 µm or more and 10 µm or less, or may be 10 µm or more and 25 µm or less.

The pitch of the second openings 41 refers to the distance P1 between the centers of two second openings 41 that are adjacent to each other in a direction in which the two second openings 41 are arranged. For example, the pitch P1 of the second openings 41 may be 1 µm or more, may be 2 µm or more, or may be 3 µm or more. For example, the pitch P1 may be 5 µm or less, may be 10 µm or less, or may be 25 µm or less. The range of the pitch P1 may be determined by using a first group consisting of 1 µm, 2 µm, and 3 µm and/or a second group consisting of 5 µm, 10 µm, and 25 µm. The range of the pitch P1 may be determined by using a combination of a value freely selected from the values in the first group described above and a value freely selected from the values in the second group described above. The range of the pitch P1 may be determined by using a combination of two values freely selected from the values in the first group described above. The range of the pitch P1 may be determined by using a combination of two values freely selected from the values in the second group described above. For example, the pitch P1 may be 1 µm or more and 25 µm or less, may be 1 µm or more and 10 µm or less, may be 1 µm or more and 5 µm or less, may be 1 µm or more and 3 µm or less, may be 1 µm or more and 2 µm or less, may be 2 µm or more and 25 µm or less, may be 2 µm or more and 10 µm or less, may be 2 µm or more and 5 µm or less, may be 2 µm or more and 3 µm or less, may be 3 µm or more and 25 µm or less, may be 3 µm or more and 10 µm or less, may be 3 µm or more and 5 µm or less, may be 5 µm or more and 25 µm or less, may be 5 µm or more and 10 µm or less, or may be 10 µm or more and 25 µm or less.

An interval S7 between the first wall surface 32 and the second openings 41 in plan view may be larger than the interval S3. This enables shadow to be inhibited from occurring at the second openings 41 close to the first wall surface 32.

The dimension S8 of the opening part 43a of each of the recessed portions 43 in plan view may be smaller than the dimension S6 of each second opening 41. For example, the dimension S8 of each opening part 43a may be 0.5 µm or more, may be 2 µm or more, or may be 3 µm or more. For example, the dimension S8 may be 5 µm or less, may be 10 µm or less, or may be 25 µm or less. The range of the dimension S8 may be determined by using a first group consisting of 0.5 µm, 2 µm, and 3 µm and/or a second group consisting of 5 µm, 10 µm, and 25 µm. The range of the dimension S8 may be determined by using a combination of a value freely selected from the values in the first group described above and a value freely selected from the values in the second group described above. The range of the dimension S8 may be determined by using a combination of two values freely selected from the values in the first group described above. The range of the dimension S8 may be determined by using a combination of two values freely selected from the values in the second group described above. For example, the dimension S8 may be 0.5 µm or more and 25 µm or less, may be 0.5 µm or more and 10 µm or less, may be 0.5 µm or more and 5 µm or less, may be 0.5 µm or more and 3 µm or less, may be 0.5 µm or more and 2 µm or less, may be 2 µm or more and 25 µm or less, may be 2 µm or more and 10 µm or less, may be 2 µm or more and 5 µm or less, may be 2 µm or more and 3 µm or less, may be 3 µm or more and 25 µm or less, may be 3 µm or more and 10 µm or less, may be 3 µm or more and 5 µm or less, may be 5 µm or more and 25 µm or less, may be 5 µm or more and 10 µm or less, or may be 10 µm or more and 25 µm or less.

The pitch of the recessed portions 43 refers to the distance P2 between the centers of two recessed portions 43 that are adjacent to each other in a direction in which the two recessed portions 43 are arranged. For example, the pitch P2 of the recessed portions 43 may be 0.7 times or more, may be 0.8 times or more, or may be 0.9 times or more the pitch P1 of the second openings 41. For example, the pitch P2 may be 1.1 times or less, may be 1.2 times or less, or may be 1.3 times or less the pitch P1. In other words, P2/P1 may be 0.7 or more, may be 0.8 or more, or may be 0.9 or more. For example, P2/P1 may be 1.1 or less, may be 1.2 or less, or may be 1.3 or less. The range of P2/P1 may be determined by a first group consisting of 0.7, 0.8, and 0.9 and/or a second group consisting of 1.1, 1.2, and 1.3. The range of P2/P1 may be determined by using a combination of a value freely selected from the values in the first group described above and a value freely selected from the values in the second group described above. The range of P2/P1 may be determined by using a combination of two values freely selected from the values in the first group described above. The range of P2/P1 may be determined by using a combination of two values freely selected from the values in the second group described above. For example, the pitch P2 may be 0.7 times or more and 1.3 times or less, may be 0.7 times or more and 1.2 times or less, may be 0.7 times or more and 1.1 times or less, may be 0.7 times or more and 0.9 times or less, may be 0.7 times or more and 0.8 times or less, may be 0.8 times or more and 1.3 times or less, may be 0.8 times or more and 1.2 times or less, may be 0.8 times or more and 1.1 times or less, may be 0.8 times or more and 0.9 times or less, may be 0.9 times or more and 1.3 times or less, may be 0.9 times or more and 1.2 times or less, may be 0.9 times or more and 1.1 times or less, may be 1.1 times or more and 1.3 times or less, may be 1.1 times or more and 1.2 times or less, or may be 1.2 times or more and 1.3 times or less the pitch P1.

For example, the number N43 of recessed portions 43 per unit area in the dummy region 481 may be 0.7 times or more, may be 0.8 times or more, or may be 0.9 times or more the number N41 of second openings 41 per unit area in the effective region 49. For example, the number N43 may be 1.1 times or less, may be 1.2 times or less, or may be 1.3 times or less the number N41. In other words, N43/N41 may be 0.7 or more, may be 0.8 or more, or may be 0.9 or more. For example, N43/N41 may be 1.1 or less, may be 1.2 or less, or may be 1.3 or less. The range of N43/N41 may be determined by a first group consisting of 0.7, 0.8, and 0.9 and/or a second group consisting of 1.1, 1.2, and 1.3. The range of N43/N41 may be determined by using a combination of a value freely selected from the values in the first group described above and a value freely selected from the values in the second group described above. The range of N43/N41 may be determined by using a combination of two values freely selected from the values in the first group described above. The range of N43/N41 may be determined by using a combination of two values freely selected from the values in the second group described above. For example, the number N43 may be 0.7 times or more and 1.3 times or less, may be 0.7 times or more and 1.2 times or less, may be 0.7 times or more and 1.1 times or less, may be 0.7 times or more and 0.9 times or less, may be 0.7 times or more and 0.8 times or less, may be 0.8 times or more and 1.3 times or less, may be 0.8 times or more and 1.2 times or less, may be 0.8 times or more and 1.1 times or less, may be 0.8 times or more and 0.9 times or less, may be 0.9 times or more and 1.3 times or less, may be 0.9 times or more and 1.2 times or less, may be 0.9 times or more and 1.1 times or less, may be 1.1 times or more and 1.3 times or less, may be 1.1 times or more and 1.2 times or less, or may be 1.2 times or more and 1.3 times or less the number N41. The number N43 of recessed portions 43 per unit area in the dummy region 481 is calculated based on the number of recessed portions 43 that fall within the region R1 surrounded by a square with a side length of 0.5 mm and having a corner in which one of the recessed portions 43 adjacent to the effective region 49 is located (see Fig. 5B).

For example, the interval S9 between the second opening 41 located at the outermost peripheral side of the effective region 49 and the recessed portion 43 closest to this second opening 41 may be 0.7 times or more, may be 0.8 times or more, or may be 0.9 times or more the pitch P1 of the second openings 41. For example, the interval S9 may be 1.1 times or less, may be 1.2 times or less, or may be 1.3 times or less the pitch P1. In other words, S9/P1 may be 0.7 or more, may be 0.8 or more, or may be 0.9 or more. For example, S9/P1 may be 1.1 or less, may be 1.2 or less, or may be 1.3 or less. The range of S9/P1 may be determined by a first group consisting of 0.7, 0.8, and 0.9 and/or a second group consisting of 1.1, 1.2, and 1.3. The range of S9/P1 may be determined by using a combination of a value freely selected from the values in the first group described above and a value freely selected from the values in the second group described above. The range of S9/P1 may be determined by using a combination of two values freely selected from the values in the first group described above. The range of S9/P1 may be determined by using a combination of two values freely selected from the values in the second group described above. For example, the interval S9 may be 0.7 times or more and 1.3 times or less, may be 0.7 times or more and 1.2 times or less, may be 0.7 times or more and 1.1 times or less, may be 0.7 times or more and 0.9 times or less, may be 0.7 times or more and 0.8 times or less, may be 0.8 times or more and 1.3 times or less, may be 0.8 times or more and 1.2 times or less, may be 0.8 times or more and 1.1 times or less, may be 0.8 times or more and 0.9 times or less, may be 0.9 times or more and 1.3 times or less, may be 0.9 times or more and 1.2 times or less, may be 0.9 times or more and 1.1 times or less, may be 1.1 times or more and 1.3 times or less, may be 1.1 times or more and 1.2 times or less, or may be 1.2 times or more and 1.3 times or less the pitch P1.

The metal layer 40 may have an alignment mark. The alignment mark of the metal layer 40 may be formed separately from the alignment marks 39 of the first layer 30 or may be formed instead of the alignment marks 39 of the first layer 30.

The intermediate layer 50 will now be described. The intermediate layer 50 includes a layer that fulfills a function for the first layer 30 or the metal layer 40. For example, the intermediate layer 50 includes a stopper layer 51 and a seed layer 52. In an example illustrated in Fig. 6A, the intermediate layer 50 is located between the first layer 30 and the metal layer 40.

The stopper layer 51 may function to stop etching at a step of processing the first layer 30 by etching. Specifically, the stopper layer 51 has resistance against etchant for etching the first layer 30. The stopper layer 51 may contain, for example, a metal material, an inorganic compound, an organic compound, or the like. Examples of the metal material include aluminum and an aluminum alloy. The aluminum alloy includes, for example, aluminum and neodymium. Examples of the inorganic compound include silicon oxides. Examples of the organic compound include resins. The organic compound may have photosensitivity. For example, the stopper layer 51 may include a photoresist. The organic compound does not need to have photosensitivity.

The thickness of the stopper layer 51 is not particularly limited provided that the metal layer 40 can be inhibited from being etched at the step of processing the first layer 30. For example, the thickness of the stopper layer 51 may be less than the thickness of the metal layer 40 or may be equal to or greater than the thickness of the metal layer 40. For example, the thickness of the stopper layer 51 may be 5 nm or more, may be 50 nm or more, or may be 75 nm or more. For example, the thickness of the stopper layer 51 may be 10 µm or less, may be 50 µm or less, or may be 100 µm or less. The range of the thickness of the stopper layer 51 may be determined by a first group consisting of 5 nm, 50 nm, and 75 nm and/or a second group consisting of 10 µm, 50 µm, and 100 µm. The range of the thickness of the stopper layer 51 may be determined by using a combination of a value freely selected from the values in the first group described above and a value freely selected from the values in the second group described above. The range of the thickness of the stopper layer 51 may be determined by using a combination of two values freely selected from the values in the first group described above. The range of the thickness of the stopper layer 51 may be determined by using a combination of two values freely selected from the values in the second group described above. For example, the thickness of the stopper layer 51 may be 5 nm or more and 100 µm or less, may be 5 nm or more and 50 µm or less, may be 5 nm or more and 10 µm or less, may be 5 nm or more and 75 nm or less, may be 5 nm or more and 50 nm or less, may be 50 nm or more and 100 µm or less, may be 50 nm or more and 50 µm or less, may be 50 nm or more and 10 µm or less, may be 50 nm or more and 75 nm or less, may be 75 nm or more and 100 µm or less, may be 75 nm or more and 50 µm or less, may be 75 nm or more and 10 µm or less, may be 10 µm or more and 100 µm or less, may be 10 µm or more and 50 µm or less, or may be 50 µm or more and 100 µm or less. As the resistance of the stopper layer 51 against the etchant for the first layer 30 becomes greater, the thickness of the stopper layer 51 can be further decreased. The thickness of the stopper layer 51 is particularly preferably 1 µm or less.

The seed layer 52 has electrical conductivity when the metal layer 40 is formed by electroplating. Specifically, the seed layer 52 may contain a material having electrical conductivity, such as a metal material and an electrically conductive oxide. Furthermore, the seed layer 52 may contain copper, nickel, chromium, tantalum, tungsten, or indium tin oxide (ITO). Such a seed layer 52 may be formed, for example, by using an electroless plating method, a sputtering method, a vacuum vapor deposition method, or an ion plating method. The seed layer 52 has a fifth surface 521 that faces the second surface 302 of the first layer 30 and a sixth surface 522 that is located opposite the fifth surface 521.

The thickness of the seed layer 52 is not particularly limited provided that the metal layer 40 can be formed. For example, the thickness of the seed layer 52 may be less than the thickness T2 of the metal layer 40 or may be equal to or greater than the thickness T2 of the metal layer 40. For example, the thickness of the seed layer 52 may be 5 nm or more, may be 50 nm or more, or may be 75 nm or more. For example, the thickness of the seed layer 52 may be 200 nm or less, may be 250 nm or less, or may be 300 nm or less. The range of the thickness of the seed layer 52 may be determined by a first group consisting of 5 nm, 50 nm, and 75 nm and/or a second group consisting of 200 nm, 250 nm, and 300 nm. The range of the thickness of the seed layer 52 may be determined by using a combination of a value freely selected from the values in the first group described above and a value freely selected from the values in the second group described above. The range of the thickness of the seed layer 52 may be determined by using a combination of two values freely selected from the values in the first group described above. The range of the thickness of the seed layer 52 may be determined by using a combination of two values freely selected from the values in the second group described above. For example, the thickness of the seed layer 52 may be 5 nm or more and 300 nm or less, may be 5 nm or more and 250 nm or less, may be 5 nm or more and 200 nm or less, may be 5 nm or more and 75 nm or less, may be 5 nm or more and 50 nm or less, may be 50 nm or more and 300 nm or less, may be 50 nm or more and 250 nm or less, may be 50 nm or more and 200 nm or less, may be 50 nm or more and 75 nm or less, may be 75 nm or more and 300 nm or less, may be 75 nm or more and 250 nm or less, may be 75 nm or more and 200 nm or less, may be 200 nm or more and 300 nm or less, may be 200 nm or more and 250 nm or less, or may be 250 nm or more and 300 nm or less.

The intermediate layer 50 may include an adhesion layer 53 between the stopper layer 51 and the seed layer 52 to improve the adhesion between the stopper layer 51 and the seed layer 52. The adhesion layer 53 may contain titanium, chromium, titanium oxide, chromium nitride, or zinc oxide. Such an adhesion layer 53 may be formed, for example, by a sol-gel method, a sputtering method, or a vacuum vapor deposition method. The thickness of the adhesion layer 53 is not particularly limited; however, for example, the thickness may be 5 nm or more, may be 6 nm or more, or may be 8 nm or more. For example, the thickness of the adhesion layer 53 may be 50 nm or less, may be 60 nm or less, or may be 70 nm or less. The range of the thickness of the adhesion layer 53 may be determined by a first group consisting of 5 nm, 6 nm, and 8 nm and/or a second group consisting of 50 nm, 60 nm, and 70 nm. The range of the thickness of the adhesion layer 53 may be determined by using a combination of a value freely selected from the values in the first group described above and a value freely selected from the values in the second group described above. The range of the thickness of the adhesion layer 53 may be determined by using a combination of two values freely selected from the values in the first group described above. The range of the thickness of the adhesion layer 53 may be determined by using a combination of two values freely selected from the values in the second group described above. For example, the thickness of the adhesion layer 53 may be 5 nm or more and 70 nm or less, may be 5 nm or more and 60 nm or less, may be 5 nm or more and 50 nm or less, may be 5 nm or more and 8 nm or less, may be 5 nm or more and 6 nm or less, may be 6 nm or more and 70 nm or less, may be 6 nm or more and 60 nm or less, may be 6 nm or more and 50 nm or less, may be 6 nm or more and 8 nm or less, may be 8 nm or more and 70 nm or less, may be 8 nm or more and 60 nm or less, may be 8 nm or more and 50 nm or less, may be 50 nm or more and 70 nm or less, may be 50 nm or more and 60 nm or less, or may be 60 nm or more and 70 nm or less.

The intermediate layer 50 is preferably located so as not to overlap the second openings 41 in plan view. This enables shadow to be inhibited from occurring due to the intermediate layer 50.

The intermediate layer 50 may have an alignment mark. The alignment mark of the intermediate layer 50 may be formed separately from the alignment marks of the first layer 30 or the alignment mark of the metal layer 40 or may be formed instead of the alignment marks of the first layer 30 or the alignment mark of the metal layer 40.

The thicknesses of the layers, the intervals, and the dimensions of component elements, for example, can be measured in a manner in which an image of a section of the mask 20 is observed by using a scanning electron microscope.

### (Method of Manufacturing Vapor Deposition Mask)

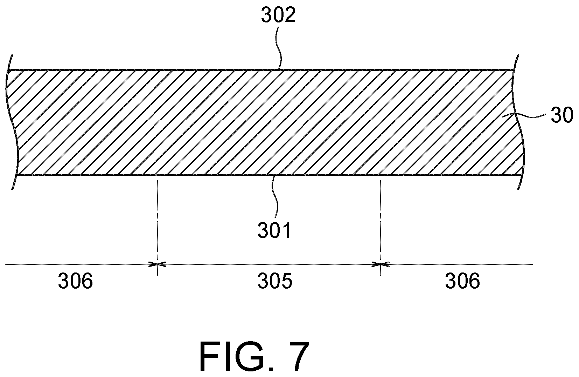

Next, a method of manufacturing a vapor deposition mask according to the present embodiment will be described with reference to Fig. 7 to Fig. 19. The first layer 30 is first prepared. The first layer 30 may be a silicon wafer. The first surface 301 and the second surface 302 of the first layer 30 may be polished into mirror surfaces. The arithmetic average roughness Ra of each of the first surface 301 and the second surface 302 may be 1.5 nm or less or may be 1.0 nm or less. The plane orientations of each of the first surface 301 and the second surface 302 may be (100), (110), or the like.

As illustrated in Fig. 7, the second surface 302 of the first layer 30 includes a first region 305 and a second region 306. The first region 305 is a region that corresponds to the first opening 31 described above. The second region 306 is a region that corresponds to the outer region 35 and inner region 36 described above. The second region 306 surrounds the first region 305.

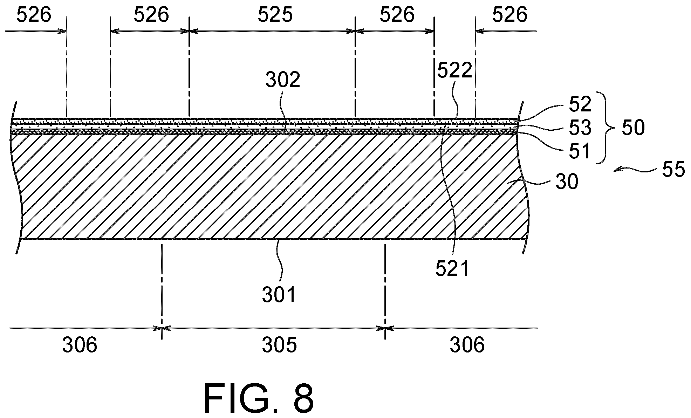

Subsequently, as illustrated in Fig. 8, the intermediate layer 50 is formed on the second surface 302 of the first layer 30 to manufacture a multilayer body 55 that includes the first layer 30 and the intermediate layer 50. Specifically, the stopper layer 51, the adhesion layer 53, and the seed layer 52 are stacked on the second surface 302 in this order. For example, the stopper layer 51 may be formed by using a vacuum film formation method such as a sputtering method. The adhesion layer 53 may be formed, for example, by a sol-gel method, a sputtering method, or a vacuum vapor deposition method. The seed layer 52 may be formed, for example, by an electroless plating method, a sputtering method, a vacuum vapor deposition method, or an ion plating method.

As illustrated in Fig. 8, the sixth surface 522 of the seed layer 52 includes a third region 525 and a fourth region 526. The third region 525 is a region that corresponds to the effective region 49 of the metal layer 40 described above. The fourth region 526 is a region that corresponds to the dummy region 481 of the metal layer 40 described above. The fourth region 526 surrounds the third region 525. The dimensions of the third region 525 and the fourth region 526 may be the same as the dimensions of the effective region 49 and the dummy region 481, respectively. The width of the fourth region 526 may be 0.6 mm or more.

The intermediate layer 50 is formed so as to cover at least the first region 305. The intermediate layer 50 may cover the second region 306. For example, the intermediate layer 50 may be formed on the entire second surface 302.

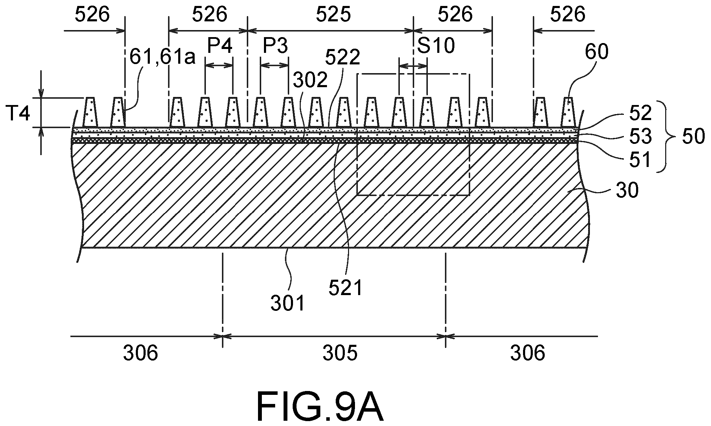

Subsequently, as illustrated in Fig. 9A, a resist pattern formation step of forming multiple resist projections 60 on the sixth surface 522 of the seed layer 52 is performed. As a result, multiple resist projections 60 that project from the sixth surface 522 are formed in the third region 525 and the fourth region 526.

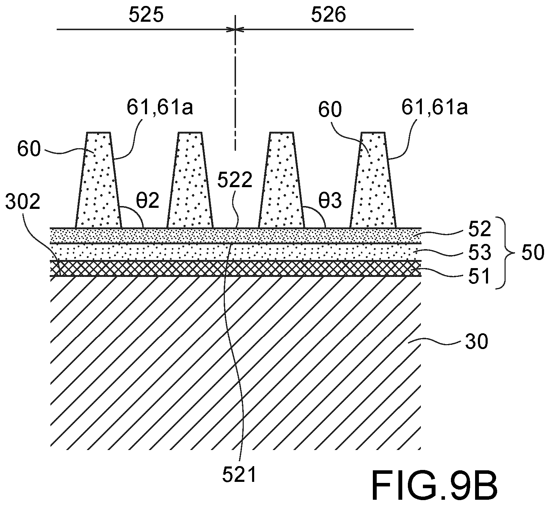

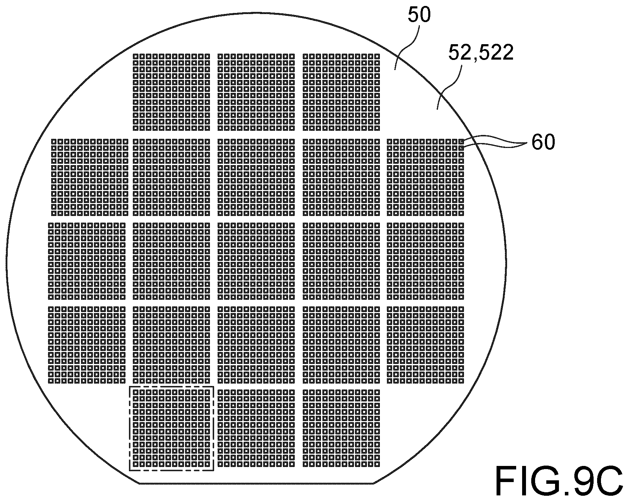

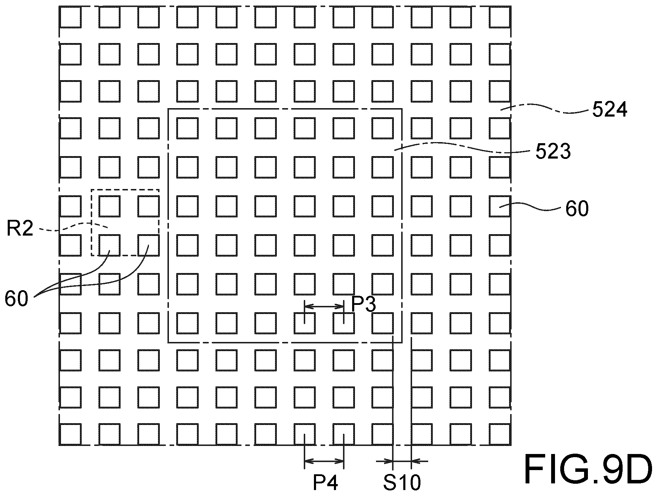

Fig. 9B is an enlarged view of a portion surrounded by the alternate long and two-short dashed line in Fig. 9A. Fig. 9C is a plan view of the seed layer 52 on which the multiple resist projections 60 are formed. Fig. 9D is an enlarged view of a portion surrounded by the alternate long and two-short dashed line in Fig. 9C. As understood by comparing Fig. 4 and Fig. 9C, the multiple resist projections 60 are formed in the third region 525 and the fourth region 526 in correspondence with the second openings 41 and the recessed portions 43.

The resist projections 60 are, for example, a photoresist. The photoresist is a positive resist. The positive resist is, for example, iP5700, PMER-P-LA900PM, and PMER-P7100, made by Tokyo Ohka Kogyo Co., Ltd., NPR9700 made by Nagase ChemteX, or the like.

The height T4 of the resist projections 60 is defined as the distance between the top portion of the resist projections 60 and the sixth surface 522. The height T4 is greater than the thickness T2 of the metal layer 40. For example, the height T4 may be 4 µm or more, may be 5 µm or more, or may be 6 µm or more. For example, the height T4 may be 7 µm or less, may be 8 µm or less, or may be 9 µm or less. The range of the height T4 may be determined by a first group consisting of 4 µm, 5 µm, and 6 µm and/or a second group consisting of 7 µm, 8 µm, and 9 µm. The range of the height T4 may be determined by using a combination of a value freely selected from the values in the first group described above and a value freely selected from the values in the second group described above. The range of the height T4 may be determined by using a combination of two values freely selected from the values in the first group described above. The range of the height T4 may be determined by using a combination of two values freely selected from the values in the second group described above. For example, the height T4 may be 4 µm or more and 9 µm or less, may be 4 µm or more and 8 µm or less, may be 4 µm or more and 7 µm or less, may be 4 µm or more and 6 µm or less, may be 4 µm or more and 5 µm or less, may be 5 µm or more and 9 µm or less, may be 5 µm or more and 8 µm or less, may be 5 µm or more and 7 µm or less, may be 5 µm or more and 6 µm or less, may be 6 µm or more and 9 µm or less, may be 6 µm or more and 8 µm or less, may be 6 µm or more and 7 µm or less, may be 7 µm or more and 9 µm or less, may be 7 µm or more and 8 µm or less, or may be 8 µm or more and 9 µm or less.

A fourth wall surface 61 of each of the resist projections 60 has a tapered surface 61a that narrows inward as a distance from the sixth surface 522 increases. Specifically, the shape of each of the resist projections 60 may be a pyramidal or circular truncated cone as a whole. The angle θ2 between the tapered surface 61a formed in the third region 525 and the sixth surface 522 of the seed layer 52 may be the same as the angle θ1 formed between the tapered surface 42a of the second opening 41 and the third surface 401. Specifically, for example, the angle θ2 may be 50° or more, may be 55° or more, may be 60° or more, or may be 65° or more. For example, the angle θ2 may be 75° or less, may be 80° or less, may be 85° or less, or may be less than 90°. The range of the angle θ2 may be determined by using a first group consisting of 50°, 55°, 60°, and 65° and/or a second group consisting of 75°, 80°, 85°, and 90°. The range of the angle θ2 may be determined by using a combination of a value freely selected from the values in the first group described above and a value freely selected from the values in the second group described above. The range of the angle θ2 may be determined by using a combination of two values freely selected from the values in the first group described above. The range of the angle θ2 may be determined by using a combination of two values freely selected from the values in the second group described above. For example, the angle θ2 may be 50° or more and less than 90°, may be 50° or more and 85° or less, may be 50° or more and 80° or less, may be 50° or more and 75° or less, may be 50° or more and 65° or less, may be 50° or more and 60° or less, may be 50° or more and 55° or less, may be 55° or more and less than 90°, may be 55° or more and 85° or less, may be 55° or more and 80° or less, may be 55° or more and 75° or less, may be 55° or more and 65° or less, may be 55° or more and 60° or less, may be 60° or more and less than 90°, may be 60° or more and 85° or less, may be 60° or more and 80° or less, may be 60° or more and 75° or less, may be 60° or more and 65° or less, may be 65° or more and less than 90°, may be 65° or more and 85° or less, may be 65° or more and 80° or less, may be 65° or more and 75° or less, may be 75° or more and less than 90°, may be 75° or more and 85° or less, may be 75° or more and 80° or less, may be 80° or more and less than 90°, may be 80° or more and 85° or less, or may be 85° or more and less than 90°. The angle θ3 between the tapered surface 61a of each of the resist projections 60 formed in the fourth region 526 and the sixth surface 522 of the seed layer 52 may be the same as the angle θ1 or may be different from the angle θ1.

The resist pattern formation step includes, for example, a first resist layer formation step, an exposure step, and a development step.

The first resist layer formation step is a step of forming a first resist layer on the sixth surface 522. The first resist layer formation step includes, for example, a step of applying liquid resist to the sixth surface 522. The first resist layer formation step may include a step of heating the liquid resist on the sixth surface 522. The first resist layer is formed by drying the liquid resist.

In the exposure step, light is applied to the first resist layer such that the first resist layer remains at portions corresponding to the second openings 41 and the recessed portions 43 in the third region 525 and the fourth region 526 in the subsequent development step and the first resist layer at the other portions on the sixth surface 522 is removed. Specifically, since the first resist layer is a positive resist, light is applied to the first resist layer at the other portions on the sixth surface 522. The light is, for example, an i-line. The i-line is a spectral line of mercury having a wavelength of 365 nm.

In the exposure step, parameters, such as light exposure and focal position, may be adjusted. For example, the light exposure may be 150 mJ/cm² or more, may be 175 mJ/cm² or more, or may be 200 mJ/cm² or more. For example, the light exposure may be 300 mJ/cm² or less, may be 350 mJ/cm² or less, or may be 400 mJ/cm² or less. The range of the light exposure may be determined by a first group consisting of 150 mJ/cm², 175 mJ/cm², and 200 mJ/cm² and/or a second group consisting of 300 mJ/cm², 350 mJ/cm², and 400 mJ/cm². The range of the light exposure may be determined by using a combination of a value freely selected from the values in the first group described above and a value freely selected from the values in the second group described above. The range of the light exposure may be determined by using a combination of two values freely selected from the values in the first group described above. The range of the light exposure may be determined by using a combination of two values freely selected from the values in the second group described above. For example, the light exposure may be 150 mJ/cm² or more and 400 mJ/cm² or less, 150 mJ/cm² or more and 350 mJ/cm² or less, may be 150 mJ/cm² or more and 300 mJ/cm² or less, may be 150 mJ/cm² or more and 200 mJ/cm² or less, may be 150 mJ/cm² or more and 175 mJ/cm² or less, may be 175 mJ/cm² or more and 400 mJ/cm² or less, may be 175 mJ/cm² or more and 350 mJ/cm² or less, may be 175 mJ/cm² or more and 300 mJ/cm² or less, may be 175 mJ/cm² or more and 200 mJ/cm² or less, may be 200 mJ/cm² or more and 400 mJ/cm² or less, may be 200 mJ/cm² or more and 350 mJ/cm² or less, may be 200 mJ/cm² or more and 300 mJ/cm² or less, may be 300 mJ/cm² or more and 400 mJ/cm² or less, may be 300 mJ/cm² or more and 350 mJ/cm² or less, or may be 350 mJ/cm² or more and 400 mJ/cm² or less. The focal position may be the sixth surface 522 of the seed layer 52 or may be shifted from the sixth surface 522. For example, the position shifted by SH µm from the sixth surface 522 toward the fifth surface 521 may be the focal position. For example, the amount of shift SH may be 1 µm or more, may be 2 µm or more, or may be 3 µm or more. For example, the amount of shift SH may be 6 µm or less, may be 8 µm or less, or may be 10 µm or less. The range of the amount of shift SH may be determined by a first group consisting of 1 µm, 2 µm, and 3 µm and/or a second group consisting of 6 µm, 8 µm, and 10 µm. The range of the amount of shift SH may be determined by using a combination of a value freely selected from the values in the first group described above and a value freely selected from the values in the second group described above. The range of the amount of shift SH may be determined by using a combination of two values freely selected from the values in the first group described above. The range of the amount of shift SH may be determined by using a combination of two values freely selected from the values in the second group described above. For example, the amount of shift SH may be 1 µm or more and 10 µm or less, may be 1 µm or more and 8 µm or less, may be 1 µm or more and 6 µm or less, may be 1 µm or more and 3 µm or less, may be 1 µm or more and 2 µm or less, may be 2 µm or more and 10 µm or less, may be 2 µm or more and 8 µm or less, may be 2 µm or more and 6 µm or less, may be 2 µm or more and 3 µm or less, may be 3 µm or more and 10 µm or less, may be 3 µm or more and 8 µm or less, may be 3 µm or more and 6 µm or less, may be 6 µm or more and 10 µm or less, may be 6 µm or more and 8 µm or less, or may be 8 µm or more and 10 µm or less. The dimensions and sectional shapes of the resist projections 60 can be controlled by adjusting these parameters. The dimensions and sectional shapes of the second openings 41 can be controlled by controlling the dimensions and sectional shapes of the resist projections 60. Particularly, the angle θ1 of the tapered surface 42a of each second opening 41 can be controlled.

After the exposure step, multiple resist projections 60 are obtained in the third region 525 and the fourth region 526 by developing the first resist layer. A developer contains, for example, tetramethylammonium hydroxide (TMAH).

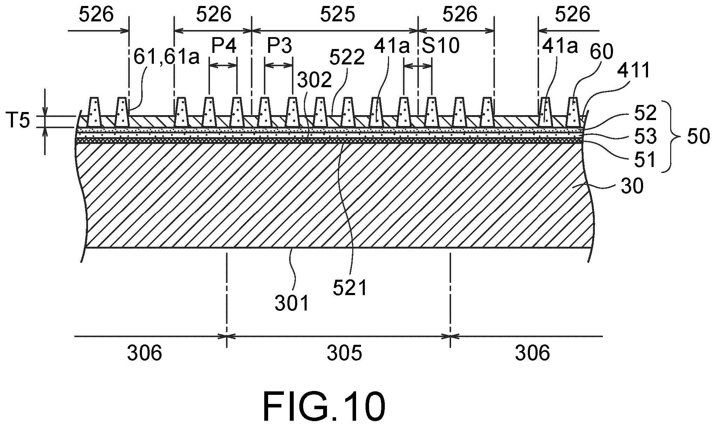

Subsequently, as illustrated in Fig. 10, a first plating step is performed. In a first plating process, the first metal layer 411 is formed on the sixth surface 522 by an electroplating process. Specifically, a plating power supply is connected to the seed layer 52, and the multilayer body 55 is immersed in a plating bath containing a plating solution. As a result, metal is precipitated in any gaps between the multiple resist projections 60 on the sixth surface 522, and the first metal layer 411 is formed. The ingredients of the plating solution are determined such that the content of nickel in the metal layer 40 is 30 mass% or more and 54 mass% or less. For example, a mixed solution of a solution containing a nickel compound and a solution containing an iron compound may be used as the plating solution. For example, a mixed solution of a solution containing nickel sulfamate or nickel bromide and a solution containing ferrous sulfamate may be used.

The thickness T5 of the first metal layer 411 is less than the height T4 of each of the resist projections 60. The thickness T5 is less than the thickness T2 of the metal layer. For example, the thickness T5 may be 2 µm or more, may be 3 µm or more, or may be 4 µm or more. For example, the thickness T5 may be 5 µm or less, may be 6 µm or less, or may be 7 µm or less. The range of the thickness T5 may be determined by using a first group consisting of 2 µm, 3 µm, and 4 µm, and/or a second group consisting of 5 µm, 6 µm, and 7 µm. The range of the thickness T5 may be determined by using a combination of a value freely selected from the values in the first group described above and a value freely selected from the values in the second group described above. The range of the thickness T5 may be determined by using a combination of two values freely selected from the values in the first group described above. The range of the thickness T5 may be determined by using a combination of two values freely selected from the values in the second group described above. For example, the thickness T5 may be 2 µm or more and 7 µm or less, may be 2 µm or more and 6 µm or less, may be 2 µm or more and 5 µm or less, may be 2 µm or more and 4 µm or less, may be 2 µm or more and 3 µm or less, may be 3 µm or more and 7 µm or less, may be 3 µm or more and 6 µm or less, may be 3 µm or more and 5 µm or less, may be 3 µm or more and 4 µm or less, may be 4 µm or more and 7 µm or less, may be 4 µm or more and 6 µm or less, may be 4 µm or more and 5 µm or less, may be 5 µm or more and 7 µm or less, may be 5 µm or more and 6 µm or less, or may be 6 µm or more and 7 µm or less. The thickness T5 can be controlled by a current value from the plating power supply, a conduction time with the plating power supply, an immersion time in the plating solution, and the like.

Multiple openings 41a corresponding to the multiple resist projections 60 are formed in the first metal layer 411. The shapes and dimensions of the openings 41a correspond to the shapes and dimensions of the tapered surfaces 61a of the corresponding resist projections 60.

Since the resist projections 60 are also formed in the fourth region 526, which surrounds the third region 525, the thickness T5 of the first metal layer 411 in the third region 525 can be made further uniform compared to the case where the resist projections 60 are formed only in the third region 525. Particularly, it is possible to inhibit the thickness T5 of the first metal layer 411 at the outer periphery of the third region 525 from being less than the thickness T5 of the first metal layer 411 at the center of the third region 525. This is presumably because the difference between a current density at the outer periphery of the third region 525 and a current density at the center of the third region 525 during the first plating step reduces due to the resist projections 60 also formed around the third region 525. In other words, this is presumably because it is possible to reduce the influence of the region in which no resist projections 60 are present outside the third region 525 on the current density at the outer periphery of the third region 525. As a result, compared to the case where the resist projections 60 are formed only in the third region 525, the dimensions of the openings 41a of the first metal layer 411 in the third region 525 can be made further uniform. Thus, compared to the case where the metal layer 40 is formed by disposing the resist projections 60 only in the third region 525, the thickness T2 of the metal layer 40 in the third region 525 can be made further uniform, so the dimensions of the second openings 41 of the metal layer 40 can be made further uniform.

From the viewpoint of making the thickness T2 of the metal layer 40 in the third region 525 further uniform, the density of the resist projections 60 in the third region 525 and the density of the resist projections 60 in the fourth region 526 are preferably comparable.

Specifically, for example, the number N526 of resist projections 60 per unit area in the fourth region 526 may be 0.7 times or more, may be 0.8 times or more, or may be 0.9 times or more the number N525 of resist projections 60 per unit area in the third region 525. For example, the number N526 may be 1.1 times or less, may be 1.2 times or less, or may be 1.3 times or less the number N525. In other words, for example, N526/N525 may be 0.7 or more, may be 0.8 or more, or may be 0.9 or more. For example, N526/N525 may be 1.1 or less, may be 1.2 or less, or may be 1.3 or less. The range of N526/N525 may be determined by a first group consisting of 0.7, 0.8, and 0.9 and/or a second group consisting of 1.1, 1.2, and 1.3. The range of N526/N525 may be determined by using a combination of a value freely selected from the values in the first group described above and a value freely selected from the values in the second group described above. The range of N526/N525 may be determined by using a combination of two values freely selected from the values in the first group described above. The range of N526/N525 may be determined by using a combination of two values freely selected from the values in the second group described above. For example, the number N526 may be 0.7 times or more and 1.3 times or less, may be 0.7 times or more and 1.2 times or less, may be 0.7 times or more and 1.1 times or less, may be 0.7 times or more and 0.9 times or less, may be 0.7 times or more and 0.8 times or less, may be 0.8 times or more and 1.3 times or less, may be 0.8 times or more and 1.2 times or less, may be 0.8 times or more and 1.1 times or less, may be 0.8 times or more and 0.9 times or less, may be 0.9 times or more and 1.3 times or less, may be 0.9 times or more and 1.2 times or less, may be 0.9 times or more and 1.1 times or less, may be 1.1 times or more and 1.3 times or less, may be 1.1 times or more and 1.2 times or less, or may be 1.2 times or more and 1.3 times or less the number N525. The number of resist projections 60 per unit area in the third region 525 is calculated based on the number of resist projections 60 that fall within the region R2 surrounded by a square with a side length of 0.5 mm and having a corner in which one of the resist projections 60 adjacent to the fourth region 526 is located (see Fig. 9D).

Alternatively, for example, the pitch P4 of the resist projections 60 in the fourth region 526 may be 0.7 times or more, may be 0.8 times or more, or may be 0.9 times or more the pitch P3 of the resist projections 60 in the third region 525. For example, the pitch P4 may be 1.1 times or less, may be 1.2 times or less, or may be 1.3 times or less the pitch P3. In other words, for example, P4/P3 may be 0.7 or more, may be 0.8 or more, or may be 0.9 or more. For example, P4/P3 may be 1.1 or less, may be 1.2 or less, or may be 1.3 or less. The range of P4/P3 may be determined by a first group consisting of 0.7, 0.8, and 0.9 and/or a second group consisting of 1.1, 1.2, and 1.3. The range of P4/P3 may be determined by using a combination of a value freely selected from the values in the first group described above and a value freely selected from the values in the second group described above. The range of P4/P3 may be determined by using a combination of two values freely selected from the values in the first group described above. The range of P4/P3 may be determined by using a combination of two values freely selected from the values in the second group described above. For example, the pitch P4 may be 0.7 times or more and 1.3 times or less, may be 0.7 times or more and 1.2 times or less, may be 0.7 times or more and 1.1 times or less, may be 0.7 times or more and 0.9 times or less, may be 0.7 times or more and 0.8 times or less, may be 0.8 times or more and 1.3 times or less, may be 0.8 times or more and 1.2 times or less, may be 0.8 times or more and 1.1 times or less, may be 0.8 times or more and 0.9 times or less, may be 0.9 times or more and 1.3 times or less, may be 0.9 times or more and 1.2 times or less, may be 0.9 times or more and 1.1 times or less, may be 1.1 times or more and 1.3 times or less, may be 1.1 times or more and 1.2 times or less, or may be 1.2 times or more and 1.3 times or less the pitch P3. The pitches P3, P4 of the resist projections 60 in the corresponding regions 525, 526 mean a distance between the centers of two resist projections 60 adjacent to each other in a direction in which the two resist projections 60 are arranged in the corresponding regions 525, 526. As will be described later, the second openings 41 are formed at portions where the resist projections 60 are disposed in the third region 525, and the recessed portions 43 are formed at portions where the resist projections 60 are disposed in the fourth region 526. Therefore, the pitch P3 is equal to the pitch P1, and the pitch P4 is equal to the pitch P2.

In order to reduce the difference between the formation conditions of the first metal layer 411 at the outermost peripheral area of the third region 525 and the formation conditions of the first metal layer 411 at the innermost area of the fourth region 526 compared to the case where the resist projections 60 are disposed only in the third region 525 to form the metal layer 40, the interval S10 between the resist projections 60 located at the outermost peripheral area of the third region 525 and the resist projections 60 in the fourth region 526, closest to those resist projections 60, is preferably comparable to the pitch P3 of the resist projections 60 in the third region 525. Specifically, for example, the interval S10 may be 0.7 times or more, may be 0.8 times or more, or may be 0.9 times or more the pitch P3. For example, the interval S10 may be 1.1 times or less, may be 1.2 times or less, or may be 1.3 times or less the pitch P3. In other words, for example, S10/P3 may be 0.7 or more, may be 0.8 or more, or may be 0.9 or more. For example, S10/P3 may be 1.1 or less, may be 1.2 or less, or may be 1.3 or less. The range of S10/P3 may be determined by a first group consisting of 0.7, 0.8, and 0.9 and/or a second group consisting of 1.1, 1.2, and 1.3. The range of S10/P3 may be determined by using a combination of a value freely selected from the values in the first group described above and a value freely selected from the values in the second group described above. The range of S10/P3 may be determined by using a combination of two values freely selected from the values in the first group described above. The range of S10/P3 may be determined by using a combination of two values freely selected from the values in the second group described above. For example, the interval S10 may be 0.7 times or more and 1.3 times or less, may be 0.7 times or more and 1.2 times or less, may be 0.7 times or more and 1.1 times or less, may be 0.7 times or more and 0.9 times or less, may be 0.7 times or more and 0.8 times or less, may be 0.8 times or more and 1.3 times or less, may be 0.8 times or more and 1.2 times or less, may be 0.8 times or more and 1.1 times or less, may be 0.8 times or more and 0.9 times or less, may be 0.9 times or more and 1.3 times or less, may be 0.9 times or more and 1.2 times or less, may be 0.9 times or more and 1.1 times or less, may be 1.1 times or more and 1.3 times or less, may be 1.1 times or more and 1.2 times or less, or may be 1.2 times or more and 1.3 times or less the pitch P3.

In the illustrated example, the resist projections 60 are arranged in a uniform array pattern from the third region 525 to the fourth region 526. The shapes and dimensions of the resist projections 60 in the fourth region 526 are the same as the shapes and dimensions of the resist projections 60 in the third region 525. As a result, the thickness of the first metal layer 411 in the third region 525 is easily controlled to be further uniform. Of course, not limited to this example, the array pattern of the resist projections 60 in the third region 525 and the array pattern of the resist projections 60 in the fourth region 526 may be different from each other. The shapes and dimensions of the resist projections 60 in the third region 525 and the shapes and dimensions of the resist projections 60 in the fourth region 526 may be different from each other. For example, each of the resist projections 60 formed in the fourth region 526 does not need to have the tapered surface 61a. In other words, each of the resist projections 60 formed in the fourth region 526 may be prismatic or cylindrical.

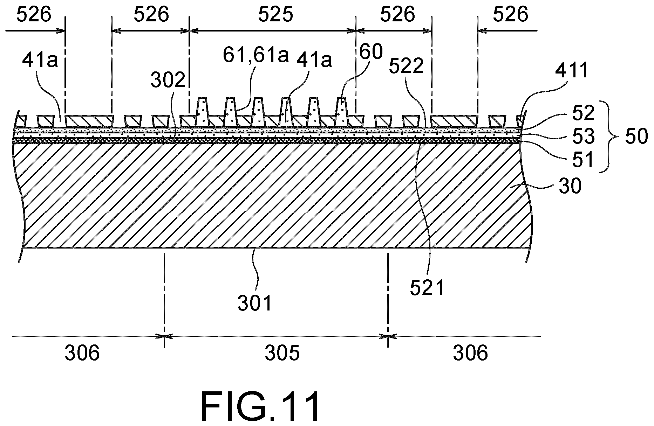

Subsequently, as illustrated in Fig. 11, the resist projections 60 formed in the fourth region 526 are removed. For example, the resist projections 60 formed in the fourth region 526 may be removed by exposing and developing the resist projections 60 formed in the fourth region 526. A developer contains, for example, tetramethylammonium hydroxide (TMAH). Alternatively, the resist projections 60 formed in the fourth region 526 may be removed by contacting the resist processing liquid with only the resist projections 60 formed in the fourth region 526. The resist processing liquid contains, for example, N-methyl-2-pyrrolidone.

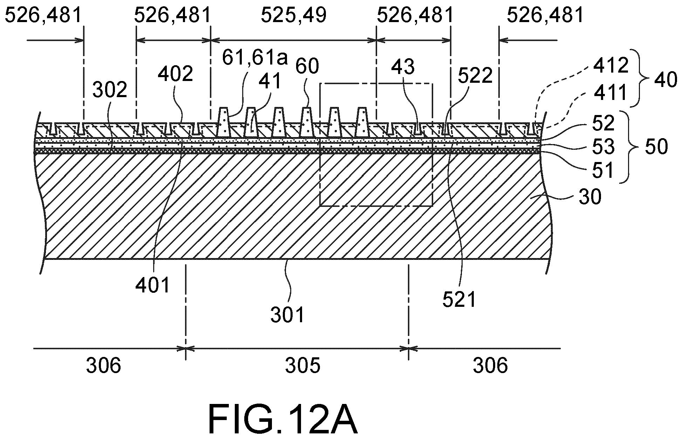

Subsequently, as illustrated in Fig. 12A, a second plating step is performed. In a second plating process, the second metal layer 412 is formed on the first metal layer 411 by an electroplating process. Thus, among the openings 41a of the first metal layer 411, the openings 41a located in the fourth region 526 are closed by the second metal layer 412, and the bottom portions 40a are formed in those openings 41a. As a result, the recessed portions 43 each having the bottom portion 40a are formed in the fourth region 526. In the illustrated example, the second metal layer 412 forms the bottom surfaces 44 of the recessed portions 43. The second metal layer 412 may cover the first metal layer 411 of the third region 525. The metal layer 40 is formed of the first metal layer 411 and the second metal layer 412. The second plating process may be performed in the same or similar manner as the first plating process. A plating solution that is used in the second plating process may be different from a plating solution that is used in the first plating process. A plating solution that is used in the first plating process and a plating solution that is used in the second plating process may be adjusted as needed respectively from the viewpoint of inhibiting the occurrence of a defect such as a pinhole, a deformation, or the like in the first metal layer 411 and the second metal layer 412 or from the viewpoint of controlling the flatness, smoothness, membrane stress, or coefficient of thermal expansion of the first metal layer 411 and the second metal layer 412.

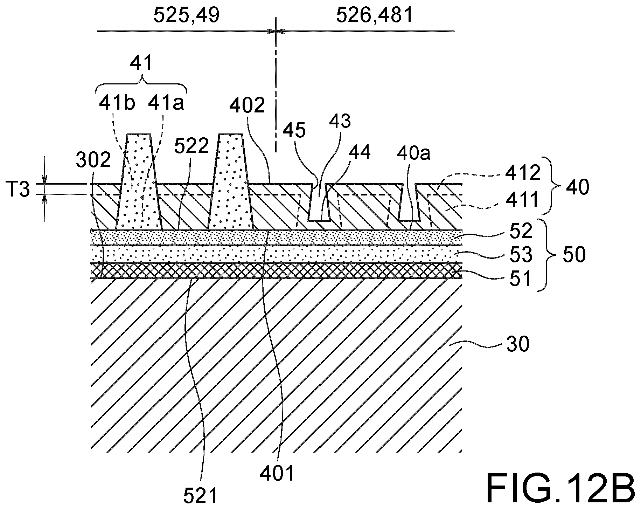

Fig. 12B is an enlarged view of a portion surrounded by the alternate long and two-short dashed line in Fig. 12A. As illustrated in Fig. 12B, the thickness T3 of the second metal layer 412 may be less than the thickness T5 of the first metal layer. The thickness T3 is determined such that the sum of the thickness T3 and the thickness T5 of the first metal layer (that is, the thickness T2 of the metal layer) is less than the height T4 of the resist projections 60. As described above, for example, the thickness T3 may be 0.5 µm or more, may be 0.75 µm or more, or may be 1.0 µm or more. For example, the thickness T3 may be 1.0 µm or less, may be 1.25 µm or less, or may be 1.5 µm or less. When the thickness T3 is 0.5 µm or more, the metal layer 40 can be inhibited, for example, from having a defect such as a pinhole and from deforming. When the thickness T3 is 1.5 µm or less, the thickness T3 of the second metal layer 412 in the third region 525 can be inhibited from becoming nonuniform. Particularly, it is possible to inhibit the thickness T3 of the second metal layer 412 at the outer periphery of the third region 525 from being less than the thickness T3 of the second metal layer 412 at the center of the third region 525. As a result, the thickness T2 of the metal layer 40 in the effective region 49 can be inhibited from becoming nonuniform, so the dimensions of the second openings 41 can be inhibited from becoming nonuniform. The thickness T3 of the second metal layer 412 can also be controlled by a current value from a plating power supply, a conduction time with the plating power supply, an immersion time in the plating solution, and the like.

In the third region 525, the resist projections 60 are disposed in the openings 41a of the first metal layer 411. As a result, in the third region 525, multiple openings 41b that are in correspondence with the multiple resist projections 60 are formed in the second metal layer 412. As a result, the second openings 41 of the metal layer 40 are formed of the openings 41a of the first metal layer 411 and the openings 41b of the second metal layer 412. The shapes and dimensions of the second openings 41 correspond to the shapes and dimensions of the tapered surfaces 60a of the corresponding resist projections 60.

In the fourth region 526, no resist projections 60 are disposed in the openings 41a of the first metal layer 411. As a result, in the fourth region 526, the second metal layer 412 may also be formed on the wall surfaces that define the openings 41a of the first metal layer 411. In this case, the dimension S8 of the opening part 43a of each recessed portion 43 may be less than the dimension of each opening 41a of the first metal layer 411.

In this manner, the metal layer 40 having the effective region 49 in which the second openings 41 are formed and the dummy region 481 in which the recessed portions 43 are formed is formed. When the metal layer 40 is formed in this way, the precision of the shapes and dimensions of the second openings 41 can be increased. Particularly, the angle θ1 between the second wall surface 42 and the fourth surface 402 has high precision. Thus, it is possible to enhance the precision of the positions, shapes, and the like of the vapor deposition layers described above.

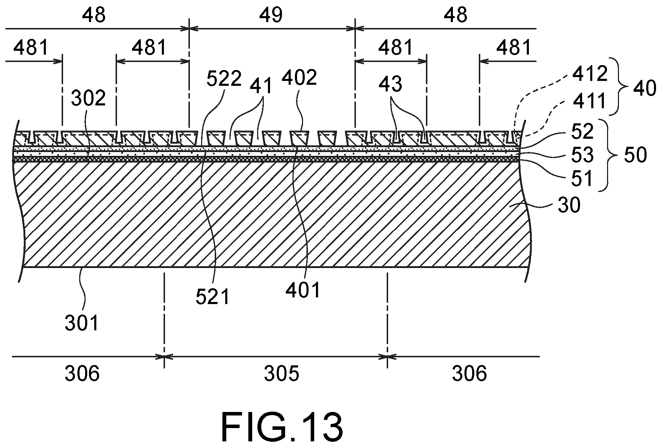

Subsequently, as illustrated in Fig. 13, the resist projections 60 of the third region 525 (that is, the resist projections 60 in the second openings 41) are removed. For example, a resist processing liquid is contacted with the resist projections 60 of the third region 525. The resist processing liquid contains, for example, N-methyl-2-pyrrolidone. The resist projections 60 may be removed by irradiating the resist projections 60 of the third region 525 with oxygen plasma.

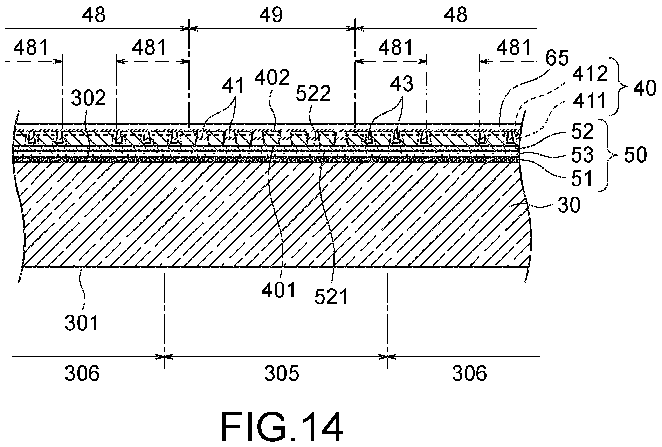

Subsequently, as illustrated in Fig. 14, a protection layer 65 is formed on the fourth surface 402 of the metal layer 40. The protection layer 65 may be a resist layer. The protection layer 65 may be formed by applying a resist solution to the metal layer 40 and solidifying the resist solution.

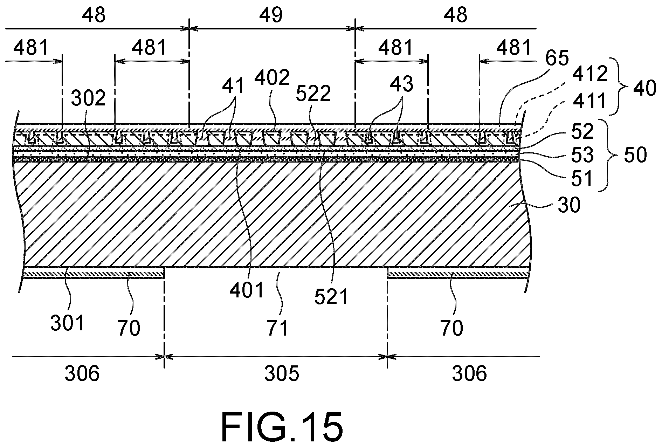

Subsequently, as illustrated in Fig. 15, a second resist formation step of partly forming a second resist layer 70 on the first surface 301 is performed. A resist opening 71 is formed in the second resist layer 70. The resist opening 71 corresponds to the first opening 31 formed in the first layer 30. The resist opening 71 overlaps the first region 305 in plan view.

The second resist layer 70 may be, for example, a photoresist. In this case, a liquid resist material is first coated on the first surface 301, and consequently, the second resist layer 70 is formed on the first surface 301. After coating, a step of heating the second resist layer 70 may be performed. Subsequently, a photolithography process of exposing and developing the second resist layer 70 is performed. Thus, the resist opening 71 can be formed in the second resist layer 70.

The second resist layer 70 may be a silicon oxide film that is partly formed on the first surface 301 although not illustrated. For example, the silicon oxide film is formed in a manner in which a thermal oxidation treatment is partly performed on the first surface 301. The silicon oxide film may be formed on the first layer 30 before the intermediate layer 50 and the metal layer 40 are stacked on the first layer 30.

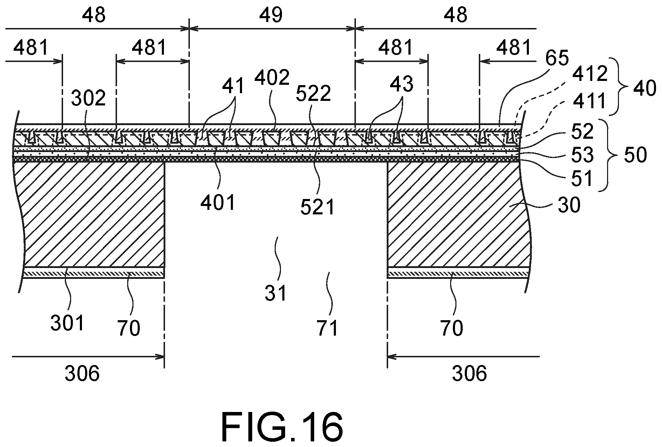

Subsequently, an etching step of etching the first layer 30 on the first surface 301 side is performed. As illustrated in Fig. 16, the first opening 31 that extends from the first surface 301 to the second surface 302 is formed in the first layer 30 in the etching step. The first opening 31 may extend to the stopper layer 51.

The etching step may be dry etching using etching gas. The etching gas is an example of the etchant described above. Since the stopper layer 51 has resistance against the etchant, etching can be inhibited from progressing up to the metal layer 40 as illustrated in Fig. 16.

In the case where the etching step is deep reactive-ion etching, for example, the etching step is performed as follows. That is, etching gas is introduced into a chamber. A voltage is applied to a space in the chamber, and consequently, the etching gas is in the state of plasma. Radicals, ions, and the like in the plasma, for example, pass through the resist opening 71 and collide with the first surface 301, and as illustrated in Fig. 16, the first opening 31 can be consequently formed in the first layer 30. An example of the etching gas is SF₆ gas.

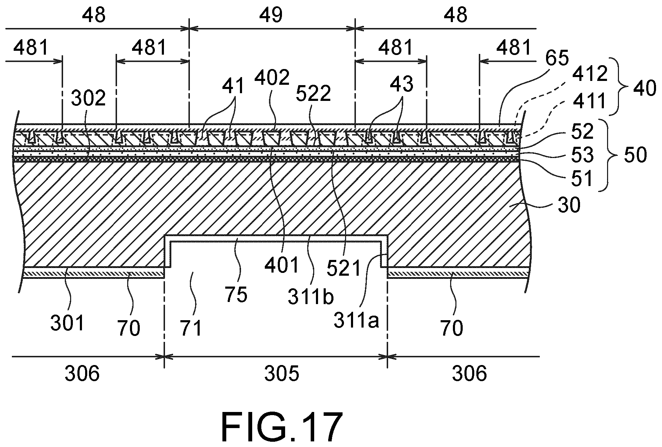

As illustrated in Fig. 17, during the etching step, a protection film 75 may be formed on the wall surface 311a and bottom surface 311b of the opening being formed in the first layer 30. In this case, a dry etching step and a protection film formation step are alternately repeated until the first opening 31 reaches the intermediate layer 50. Thus, the first opening 31 that extends from the first surface 301 to the second surface 302 can be formed.

The protection film 75 can be formed, for example, by switching gas to be introduced into the chamber from etching gas to source gas. An example of the source gas is C₄F₈ gas. A voltage is applied to the space in the chamber, and consequently, the source gas is in the state of plasma. Radicals and the like in the plasma react at the wall surface 311a and bottom surface 311b of the opening being formed in the first layer 30, and as illustrated in Fig. 17, the protection film 75 can be consequently formed on the wall surface 311a and the bottom surface 311b.

After the etching step, a protection film removal step of removing the protection film 75 may be performed. For example, a protection film processing liquid is supplied to the first opening 31 of the first layer 30. The first layer 30 may be immersed in a tank containing a protection film processing liquid. The protection film processing liquid contains, for example, hydrofluoroether.

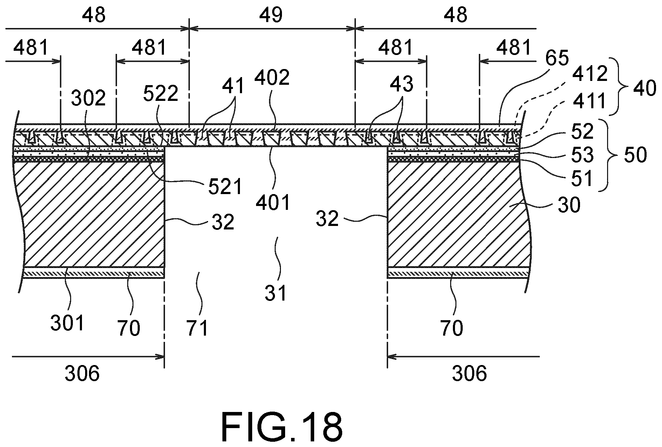

After the etching step, an intermediate layer removal step of removing the intermediate layer 50 is performed. For example, etchant for the intermediate layer 50 is supplied to the first opening 31. As illustrated in Fig. 18, this enables the intermediate layer 50 that overlaps the first opening 31 in plan view to be removed. The intermediate layer 50 may be etched by dry etching using a fluorine gas or the like or wet etching using an acidic etchant.

The first opening 31 is formed in the first layer 30, and additionally the intermediate layer 50 is removed, with the result that the second openings 41 of the effective region 49 and the first opening 31 communicate with each other. On the other hand, the recessed portions 43 formed in the dummy region 481 do not communicate with the first opening 31 due to the presence of the bottom portions 40a formed by the second metal layer 412.

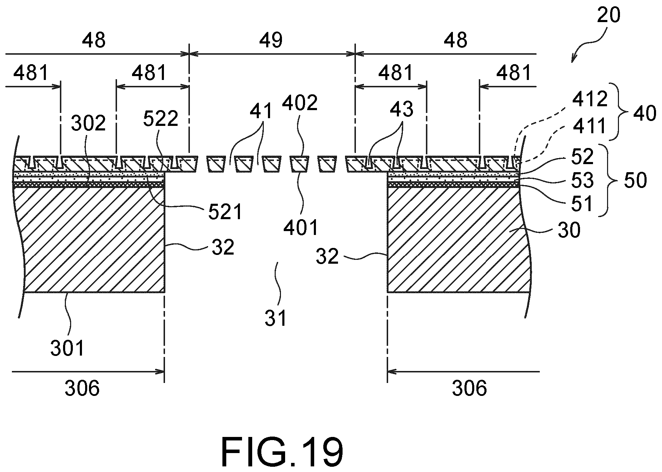

As illustrated in Fig. 19, after the etching step, a protection layer removal step of removing the protection layer 65 is performed. For example, a resist processing liquid is supplied to the protection layer 65. In the case where the protection layer 65 is a photoresist, the resist processing liquid contains, for example, N-methyl-2-pyrrolidone. The protection layer 65 may be removed by irradiating the protection layer 65 with oxygen plasma. In the case where the protection layer 65 is a silicon oxide film, the resist processing liquid contains, for example, hydrofluoric acid. The protection layer 65 may be removed by dry etching using CF₄ gas, for example.

As illustrated in Fig. 19, a second resist removal step of removing the second resist layer 70 may be performed after the etching step. The second resist removal step may be performed in the same or similar manner as the protection layer removal step. The second resist layer 70 may be removed together with the protection layer 65 in the protection layer removal step.

Next, an example of a method of manufacturing the organic device 100 by using the mask 20 will now be described.

The substrate 110 on which the first electrodes 120 are formed is first prepared. The substrate 110 may be a silicon wafer. For example, the first electrodes 120 may be formed in a manner in which a conductive layer for forming the first electrodes 120 is formed on the substrate 110 by using, for example, the vacuum film formation method, and subsequently, the conductive layer is patterned by using a photolithography method or the like. The conductive layer may be patterned by using an apparatus that performs a semiconductor manufacturing process. Each insulating layer 160 that is located between two of the first electrodes 120 adjacent to each other may be formed on the substrate 110.

Subsequently, the organic layers 130 that include, for example, the first organic layers 130A and the second organic layers 130B are formed on the first electrodes 120. For example, initially, the first organic layers 130A are formed by using the vapor deposition method in which the first mask 20 is used. The first mask 20 has the second openings 41 that correspond to the first organic layers 130A. Subsequently, the second organic layers 130B are formed by using the vapor deposition method in which the second mask 20 is used. The second mask 20 has the second openings 41 that correspond to the second organic layers 130B. Subsequently, the third organic layers are formed by using the vapor deposition method in which the third mask 20 is used. The third mask 20 has the second openings 41 that correspond to the third organic layers.

Subsequently, the second electrodes 140 are formed on the organic layers 130. For example, as illustrated in Fig. 1, the second electrodes 140 may be formed on the entire first surface 111 by using a vacuum film formation method or the like. Alternatively, the second electrodes 140 may be formed by using a vapor deposition method in which the mask 20 is used as in the case of the organic layers 130 although not illustrated. Subsequently, a sealing layer or the like (not illustrated) may be formed on the second electrodes 140. In this way, the organic device 100 can be obtained.

Multiple organic devices 100 may be formed on the single substrate 110. Each of the organic devices 100 may correspond to one of the first openings 31 of the mask 20. In this case, a step of cutting the substrate 110 may be performed. For example, the substrate 110 is cut along a region of the substrate 110 that corresponds to the inner region 36 of the mask 20. This enables multiple organic devices 100 to be obtained.

The effects of the mask 20 in the case where the organic layers 130, the second electrode 140, and the like are formed by using a vapor deposition method in which the mask 20 is used will be described.

The mask 20 includes the first layer 30 that contains silicon or a silicon compound. For this reason, in the case where the substrate 110 contains silicon, the thermal expansion of the substrate 110 and the thermal expansion of the mask 20 can be inhibited from differing from each other. This enables the precision of the positions, shapes, and the like of vapor deposition layers such as the organic layers 130 and the second electrode 140 to be inhibited from being reduced due to the thermal expansion of the mask 20. Accordingly, the organic device 100 that has a high element density can be provided.

The mask 20 includes the metal layer 40 that has the multiple second openings 41. The metal layer 40 is provided separately from the first layer 30, and the thickness T2 of the metal layer 40 can be consequently decreased. This enables shadow to be inhibited from occurring at a vapor deposition step. The interval S7 between the first wall surface 32 and the second openings 41 in plan view is appropriately ensured, and consequently, the thickness of the first layer 30 can be appropriately ensured while shadow is inhibited from occurring. Thus, it is possible to suppress damage to the first layer 30 when handling the mask 20, for example, when moving the mask. The metal layer 40 in which the second openings 41 are formed can be attracted toward the substrate 110 by the magnetic force of the magnet 5. This enables a gap between the mask 20 and the substrate 110 to be reduced or enables the gap to be eliminated. This enables shadow to be inhibited from occurring at a vapor deposition step.

Since the angle θ1 between the fourth surface 402 of the metal layer 40 and the second wall surface 42 has high precision, it is possible to enhance the precision of the positions, shapes, and the like of the vapor deposition layers.

Since the metal layer 40 is connected to the first layer 30 via the intermediate layer 50, it is possible to suppress scattering of fragments of the first layer 30 even when the first layer 30 is damaged.

The peripheral region 48 of the metal layer 40 of the mask 20 is fixed to the second surface 302 of the first layer 30. Therefore, the effective region 49 of the metal layer 40 can be inhibited from deflecting. This enables the positions of the second openings 41 formed in the effective region 49 to be inhibited from changing.

The embodiment described above can be modified in various ways. For example, in the example described above, the metal layer 40 is formed by an electroplating method; however, the method of forming the metal layer 40 is not limited thereto. The metal layer 40 may be formed by using an electroless plating method. The intermediate layer 50 does not need to have the stopper layer 51 or the adhesion layer 53. In this case, the seed layer 52 may be in contact with the second surface 302 of the first layer 30. The mask 20 does not need to include the intermediate layer 50. In this case, the metal layer 40 may be in contact with the second surface 302 of the first layer 30. The fourth surface 402 of the metal layer 40 may be planarized by polishing. When the fourth surface 402 of the metal layer 40 is planarized, a gap can be inhibited from occurring between the metal layer 40 and the component elements on the substrate 110. This can also contribute to inhibition of shadow. Mechanical polishing, chemical mechanical polishing, wet etching, dry etching, and combinations of them can be employed as methods of planarizing the fourth surface 402 of the metal layer 40.

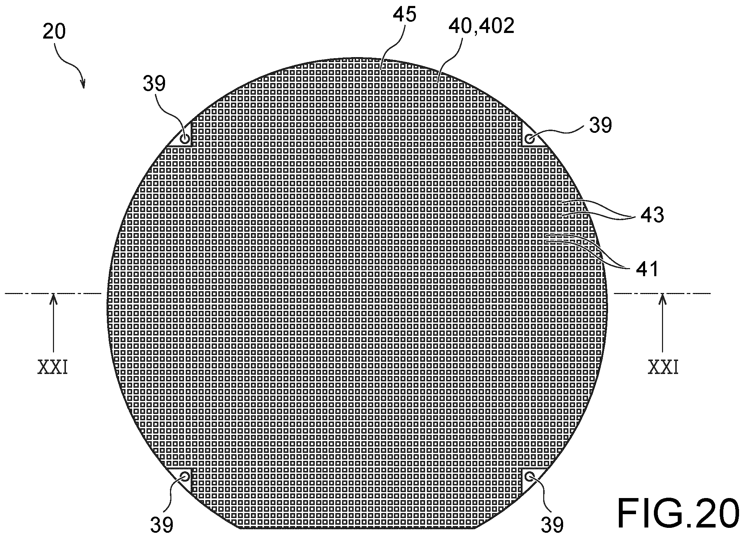

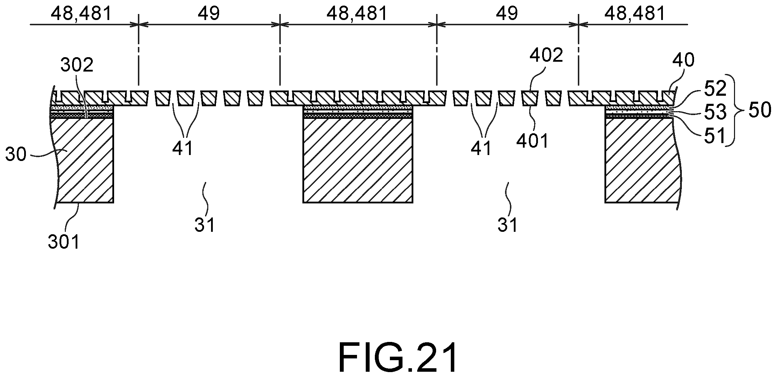

The example described above has described that a part of the peripheral region 48 is the dummy region 481; however, the configuration is not limited thereto. As illustrated in Fig. 20 and Fig. 21, the entire or almost the entire area of the peripheral region 48 may be the dummy region 481. Fig. 20 is a view of the mask 20 according to this modification when viewed from a position in front of the exit surface 202. Fig. 21 is a partially sectional view of the mask 20 taken along the line XXI-XXI in Fig. 20. In the example shown in Fig. 20 and Fig. 21, the dummy region 481 is formed in the entire area of the peripheral region 48 except the areas that overlap the alignment marks 39 and its surrounding regions in plan view.

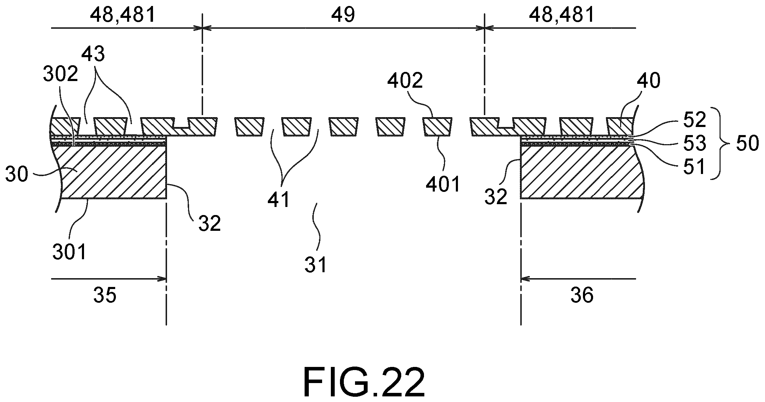

The example described above has described that the second metal layer 412 is formed over the entire area of the dummy region 481; however, the configuration is not limited thereto. The second metal layer 412 may be formed only in part of the dummy region 481. In other words, among the recessed portions 43 formed in the dummy region 481, only some of the recessed portions 43 may have a bottom portion 40a formed by the second metal layer 412. Specifically, as illustrated in Fig. 22, among the recessed portions 43 of the dummy region 481, only the recessed portions 43 that overlap the first opening 31 in plan view may have a bottom portion 40a formed by the second metal layer 412. In this case, the bottom surfaces 44 of the other recessed portions 43 may be formed by the intermediate layer 50 or the first layer 30. Furthermore, the metal layer 40 does not need to include the second metal layer 412. Specifically, in the dummy region 481, when there are no recessed portions 43 overlapping the first opening 31 in plan view, the second metal layer 412 does not need to be formed on the first metal layer 411. In these cases as well, since the first opening 31 and the recessed portions 43 do not communicate with each other, when a vapor deposition layer is formed on the substrate 110 by using the mask 20, adhesion of vapor deposition material from the vapor deposition source 6 to the substrate 110 through the recessed portions 43 is suppressed.

When the metal layer 40 does not include the second metal layer 412, the second plating step does not need to be performed. In this case, the recessed portions 43 may extend over the entire thickness T2 of the metal layer 40. When only some of the recessed portions 43 have a bottom portion 40a formed by the second metal layer 412 as well, the other recessed portions 43 may extend over the entire thickness T2 of the metal layer 40. In this case, the second plating step may be performed only in a part of the fourth region 526. In this case, the second plating step may only be performed in the area of the fourth region 526, which overlaps the first region 305 in plan view.

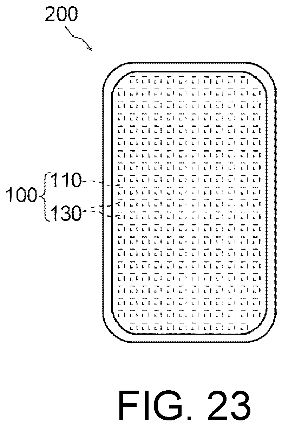

Fig. 23 illustrates an example of a device 200 that includes the organic device 100. The device 200 includes the substrate 110 and the organic layers 130. The organic layers 130 are formed by using a vapor deposition method in which the mask 20 is used. An example of the device 200 is a smartphone. The device 200 may be a tablet terminal or a wearable terminal. Examples of the wearable terminal include smart glasses and a head-mounted display.

Multiple component elements that are disclosed in the embodiments and the modifications described above can be appropriately combined as needed. Some component elements may be removed from all of the component elements that are disclosed in the embodiments and the modifications described above.

### Reference Signs List

10: vapor deposition apparatus, 20: mask, 201: entrance surface, 202: exit surface, 30: first layer, 301: first surface, 302: second surface, 305: first region, 306: second region, 31: first opening, 32: first wall surface, 40: metal layer, 401: third surface, 402: fourth surface, 41: second opening, 43: recess, 48: peripheral region, 481: dummy region, 49: effective region, 411: first metal layer, 412: second metal layer, 50: intermediate layer, 51: stopper layer, 52: seed layer, 521: fifth surface, 522: sixth surface, 53: adhesion layer, 100: organic device

## Claims

1. A mask comprising:
a first layer having a first surface, a second surface that is located opposite the first surface, and at least one first opening that extends from the first surface to the second surface; and
a metal layer having a third surface that faces the second surface, a fourth surface that is located opposite the third surface, and multiple second openings that extend from the third surface to the fourth surface and that overlap the at least one first opening in plan view, wherein
the first layer contains silicon or a silicon compound,
the metal layer has an effective region where the multiple second openings are formed and a peripheral region surrounding the effective region,
the peripheral region includes a dummy region that is adjacent to the effective region so as to surround the effective region in a circumferential shape, and multiple recessed portions recessed from the fourth surface toward the third surface are formed in the dummy region.

2. The mask according to claim 1, further comprising a seed layer that is located between the second surface and the third surface.

3. The mask according to claim 2, wherein the seed layer has electrical conductivity.

4. The mask according to claim 1, further comprising a stopper layer between the second surface and the third surface.

5. The mask according to claim 1, wherein
each of the second openings is defined by a wall surface connecting the third surface to the fourth surface, and
the wall surface has a tapered surface that widens outward toward the fourth surface.

6. The mask according to claim 1, wherein a width of the dummy region is 0.6 mm or more.

7. The mask according to claim 1, wherein the number of the recessed portions per unit area in the dummy region is 0.7 times or more and 1.3 times or less the number of the second openings per unit area in the effective region.

8. The mask according to claim 1, wherein a pitch of the recessed portions is 0.7 times or more and 1.3 times or less a pitch of the second openings.

9. The mask according to claim 1, wherein an interval between a second opening of the second openings that is located at an outermost peripheral side of the effective region and a recessed portion of the recessed portions that is closest to the second opening that is located at the outermost peripheral side is 0.7 times or more and 1.3 times or less a pitch of the second openings.

10. The mask according to claim 1, wherein
a thickness of the metal layer is 2 µm or more and 7 µm or less,
each of the recessed portions extends over a part of a thickness of the metal layer from the fourth surface, and
a thickness of a bottom portion of each of the recessed portions is 0.5 µm or more and 1.5 µm or less.

11. A method of manufacturing a mask, the method comprising: a step of preparing a multilayer body including a first layer having a first surface and a second surface that is located opposite the first surface, and a seed layer having a fifth surface that faces the second surface and a sixth surface that is located opposite the fifth surface;
a step of providing a first resist layer containing a positive resist on the sixth surface of the seed layer;
a step of forming multiple resist projections projecting from the sixth surface in a third region and a fourth region surrounding the third region on the sixth surface by exposing and developing the first resist layer;
a step of performing a first plating process to form a first metal layer having multiple openings corresponding to the multiple resist projections by precipitating metal on the sixth surface, where the multiple resist projections are formed in the third region and the fourth region;
a step of removing resist projections of the multiple resist projections that are located in the fourth region;
a step of removing resist projections of the multiple resist projections that are located in the third region;
a step of partly forming a second resist layer on the first surface of the first layer; and
a step of forming a first opening in the first layer by etching the first layer from the first surface side, wherein
each of the resist projections that are located in the third region has a tapered surface that narrows inward as a distance from the sixth surface increases.

12. The method of manufacturing a mask according to claim 11, further comprising a step of performing a second plating process to form a second metal layer that closes at least part of openings in the first metal layer that are located in the fourth region by precipitating the second metal layer on the first metal layer and the sixth surface, after the step of removing the resist projections that are located in the fourth region and before the step of removing the resist projections that are located in the third region.

13. The method of manufacturing a mask according to claim 12, wherein
the seed layer has electrical conductivity, and
the first plating process and the second plating process are electroplating processes.

14. The method of manufacturing a mask according to claim 11, further comprising a step of removing part of the seed layer that overlaps the first opening in plan view, after the step of forming the first opening in the first layer.

15. The method of manufacturing a mask according to claim 11, wherein
the multilayer body includes a stopper layer between the first layer and the seed layer, and
the method of manufacturing a mask further comprises a step of removing the stopper layer after the step of forming the first opening in the first layer.

16. The method of manufacturing a mask according to claim 12, further comprising:
a step of forming a protection layer covering the second metal layer after the second plating process and before the first opening is formed; and
a step of removing the protection layer after the first opening is formed in the first layer.

17. The method of manufacturing a mask according to claim 11, wherein a width of the fourth region is 0.6 mm or more.

18. The method of manufacturing a mask according to claim 12, wherein
a thickness of the first metal layer is 0.5 µm or more and 6.5 µm or less, and
a thickness of the second metal layer is 0.5 µm or more and 1.5 µm or less.
